# EUROPEAN PATENT APPLICATION

(11) **EP 4 718 963 A1**
(43) Date of publication of application: **01.04.2026**
(21) Application number: 23938413.4
(22) Date of filing: 22.05.2023
(51) Int. Cl.: H05K 9/00, F16J 15/3204, F16J 15/3272

(54) **ELECTRICALLY CONDUCTIVE STRUCTURE AND ELECTRICALLY CONDUCTIVE SEALING DEVICE**

(71) Applicant: NOK Corporation, Minato-ku Tokyo 105-8585 (JP)
(72) Inventor: YOSHIMURA, Kenichi, Fukushima-shi Fukushima 960-1193 (JP); KAMIYA, Yusuke, Fukushima-shi Fukushima 960-1193 (JP); OHASHI, Shota, Fukushima-shi Fukushima 960-1193 (JP); TAKAMATSU, Shunpei, Kitaibaraki-shi, Ibaraki 319-1535 (JP)
(74) Representative: TBK
(86) International application number: PCT/JP2023/019008
(87) International publication number: WO 2024/241442

(57) **Abstract**

An electrically conductive structure that enables saving of space and, in a use state, reducing a decrease in electrically conductive performance is provided. An electrically conductive structure (1) includes: a holding member (2) that is an annular member with electrical conductivity around an axis x; and an electrically conductive member (3) that is an annular member around the axis (x). The electrically conductive member (3) has at least one gap (10) formed to extend in a radial direction and includes at least one electrical conductor (20) with electrical conductivity extending around the axis x. The electrically conductive member (3) is held by the holding member (2). The electrical conductor (20) has a pair of ends (20a, 20b) in a direction around the axis x. The gap (10) is continuous with the ends (20a, 20b) of the electrical conductor (20).

## Description

### [Technical Field]

The present invention relates to an electrically conductive structure and an electrically conductive sealing device, in particular an electrically conductive structure and an electrically conductive sealing device that form an electrically conductive path at a rotating shaft.

### [Background Art]

There are cases where, for example, a vehicle equipped with an electric motor, such as an electric vehicle (EV: Electric Vehicle), suffers the generation of an electromagnetic noise due to an induced current generated by the motor, or the like. Such an electromagnetic noise leads to a communication failure of an AM radio or another wireless communication equipment in some cases. Such an electromagnetic noise also results in electrolytic corrosion of a metal part such as a bearing in some cases. Accordingly, an approach to removing such an electromagnetic noise has been applied and there have been proposed an electrically conductive structure and an electrically conductive device that form an electrically conductive path at a rotary shaft. For example, according to a disclosed technology (see, for example, Patent Literature 1), an oil seal sealing a rotary shaft of a motor is an oil seal made of an electrically conductive rubber and an electrically conductive path is formed at the rotary shaft to release an electromagnetic noise from the rotary shaft into a housing.

### [Citation List]

### [Patent Literature]

Patent Literature 1: Japanese Patent Application Publication No. 2000-244180

### [Summary of the Invention]

### [Technical Problem]

A lubricant is applied to an oil seal for the purpose of lubrication and, in a use state, an oil film is formed between a seal lip and a rotary shaft. A lubricant with electrical conductivity is applied to an oil seal including an electrically conductive rubber for the purpose of lubrication. Even though an oil film formed between the electrically conductive seal lip and the rotary shaft is made of a lubricant with electrical conductivity, the oil film is likely to serve as a resistance to a current between the electrically conductive seal lip and the rotary shaft. Thus, even though the lubricant with electrical conductivity is applied, an electrical conductivity between the seal lip and the rotary shaft decreases in some cases. In contrast, the oil seal including the electrically conductive rubber requires no additional space in an attachment space for the oil seal. As seen from the above, while enabling saving of space, a conventional electrically conductive structure or electrically conductive device is likely to decrease in electrically conductive performance in the use state. Accordingly, for a conventional electrically conductive structure or electrically conductive device, there is a demand for a configuration that enables saving of space and, in the use state, reducing a decrease in electrically conductive performance.

The present invention is made in view of the above-described problem and an object of the present invention is to provide an electrically conductive structure and an electrically conductive sealing device that enable saving of space and, in a use state, reducing a decrease in electrically conductive performance.

### [Solution to Problem]

In order to achieve the above-described object, an electrically conductive structure according to the present invention includes: a holding member that is an annular member with electrical conductivity around an axis; and an electrically conductive member that is an annular member around the axis, in which the electrically conductive member has at least one gap formed to extend in a radial direction and includes at least one electrical conductor with electrical conductivity extending around the axis, the electrically conductive member is held by the holding member, the electrical conductor has a pair of ends in a direction around the axis, and the gap is continuous with the ends of the electrical conductor.

In the electrically conductive structure according to an aspect of the present invention, the electrically conductive member includes the single electrical conductor and has the single gap, the pair of ends of the electrical conductor face each other in the direction around the axis, and the gap is a gap between the facing ends of the electrical conductor.

In the electrically conductive structure according to an aspect of the present invention, the electrically conductive member includes the two electrical conductors and has the two gaps, one of the pair of ends of one of the electrical conductors faces one of the pair of ends of the other one of the electrical conductors in the direction around the axis, the other one of the pair of ends of the one of the electrical conductors faces the other one of the pair of ends of the other one of the electrical conductors in the direction around the axis, one of the gaps is formed between the one of the ends of the one of the electrical conductors and the one of the ends of the other one of the electrical conductors, and the other one of the gaps is formed between the other one of the ends of the one of the electrical conductors and the other one of the ends of the other one of the electrical conductors.

In the electrically conductive structure according to an aspect of the present invention, the electrical conductor is held by the holding member on an outer peripheral side.

The electrically conductive structure according to an aspect of the present invention includes an annular spring member around the axis, in which the spring member is configured to generate an elastic force in a direction toward the axis, and the spring member and the electrically conductive member are provided side by side in a direction of the axis.

In the electrically conductive structure according to an aspect of the present invention, the holding member includes at least one projecting portion that is to be housed in the gap, and the projecting portion projects in a direction of the axis.

In the electrically conductive structure according to an aspect of the present invention, the electrical conductor is made of PTFE with electrical conductivity.

In order to achieve the above-described object, an electrically conductive sealing device according to the present invention is an electrically conductive sealing device for sealing between a shaft and a hole where the shaft is inserted, the electrically conductive sealing device including: a reinforcing ring that is an annular member around an axis; an elastic body portion formed of an annular elastic body around the axis attached to the reinforcing ring; and an annular electrically conductive structure around the axis, in which the elastic body portion includes a seal lip that comes into contact with the shaft, the electrically conductive structure includes a holding member that is an annular member around the axis and an electrically conductive member that is an annular member around the axis, the electrically conductive member has at least one gap extending in a radial direction and includes at least one electrical conductor with electrical conductivity extending around the axis, the holding member is attached to the elastic body portion with the electrical conductor held between the holding member and the elastic body portion, the electrical conductor has a pair of ends in a direction around the axis, and the gap is continuous with the ends of the electrical conductor.

In the electrically conductive sealing device according to an aspect of the present invention, the electrically conductive member includes the single electrical conductor and has the single gap, the pair of ends of the electrical conductor face each other in the direction around the axis, and the gap is a gap between the facing ends of the electrical conductor.

In the electrically conductive sealing device according to an aspect of the present invention, the electrically conductive member includes the two electrical conductors and has the two gaps, one of the pair of ends of one of the electrical conductors faces one of the pair of ends of the other one of the electrical conductors in the direction around the axis, the other one of the pair of ends of the one of the electrical conductors faces the other one of the pair of ends of the other one of the electrical conductors in the direction around the axis, one of the gaps is formed between the one of the ends of the one of the electrical conductors and the one of the ends of the other one of the electrical conductors, and the other one of the gaps is formed between the other one of the ends of the one of the electrical conductors and the other one of the ends of the other one of the electrical conductors.

In the electrically conductive sealing device according to an aspect of the present invention, the holding member includes at least one projecting portion that is to be housed in the gap, and the projecting portion projects in a direction of the axis.

In the electrically conductive sealing device according to an aspect of the present invention, the electrical conductor is made of PTFE with electrical conductivity.

### [Advantageous Effects of the Invention]

According to the present invention, it is possible to provide an electrically conductive structure and an electrically conductive sealing device that enable saving of space and, in the use state, reducing a decrease in electrically conductive performance.

### [Brief Description of the Drawings]

Fig. is a perspective view illustrating a schematic configuration of an electrically conductive structure according to a first embodiment of the present invention.
Fig. 2 is a front view of the electrically conductive structure illustrated in Fig. 1.
Fig. 3 is a cross-sectional view illustrating one side with respect to an axis in a cross section defined by a plane including the axis of the electrically conductive structure illustrated in Fig. 1.
Fig. 4 is a front view of an electrically conductive member of the electrically conductive structure illustrated in Fig. 1.
Fig. 5 is a cross-sectional view illustrating a modification example of an electrical conductor.
Fig. 6 is a cross-sectional view illustrating a modification example of the electrical conductor.
Fig. 7 is a cross-sectional view of a cross section along a line A-A in Fig. 2.
Fig. 8 is a cross-sectional view of a cross section along a line B-B in Fig. 2.
Fig. 9 is a schematic diagram for illustrating an example of an installation object of the electrically conductive structure illustrated in Fig. 1.
Fig. 10 is a cross-sectional view illustrating an example of a use state of the electrically conductive structure illustrated in Fig. 1 in the installation object illustrated in Fig. 9.
Fig. 11 is a front view of an electrically conductive member 3 according to a modification example.
Fig. 12 is a perspective view illustrating a schematic configuration of an electrically conductive configuration body according to a second embodiment of the present invention.
Fig. 13 is a cross-sectional perspective view with a partial cutaway of the electrically conductive configuration body illustrated in Fig. 12.
Fig. 14 is a front view of the electrically conductive structure illustrated in Fig. 12.
Fig. 15 is a cross-sectional view illustrating one side with respect to an axis in a cross section defined by a plane including the axis of the electrically conductive structure illustrated in Fig. 12.
Fig. 16 is a cross-sectional view of a schematic configuration of an electrically conductive sealing device according to the first embodiment of the present invention, illustrating, one side with respect to an axis in a cross section defined by a plane including the axis of the electrically conductive sealing device.
Fig. 17 is a schematic diagram for illustrating an example of an installation object of the electrically conductive sealing device illustrated in Fig. 16.
Fig. 18 is a cross-sectional view illustrating an example of a use state of the electrically conductive sealing device 5 illustrated in Fig. 16 in the installation object illustrated in Fig. 17.
Fig. 19 is a front view of an electrically conductive member according to a modification example.
Fig. 20 is a cross-sectional view of an electrically conductive sealing device according to a modification example attached with the electrically conductive member in Fig. 19.

### [Description of Embodiments]

Description will be made below on an embodiment of the present invention with reference to the drawings. It should be noted that there are cases where a plurality of components are not all labelled with respective reference signs and the reference signs of some of the plurality of components are omitted in the drawings.

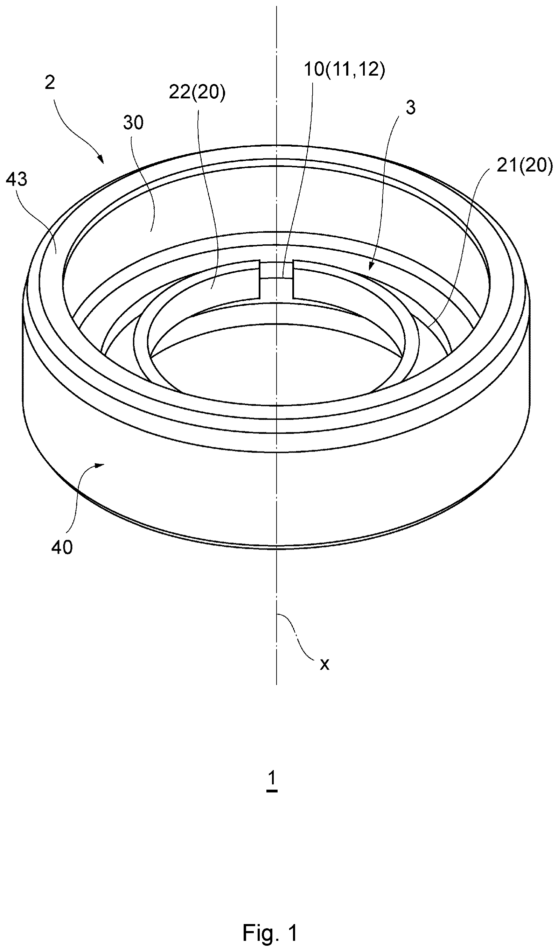

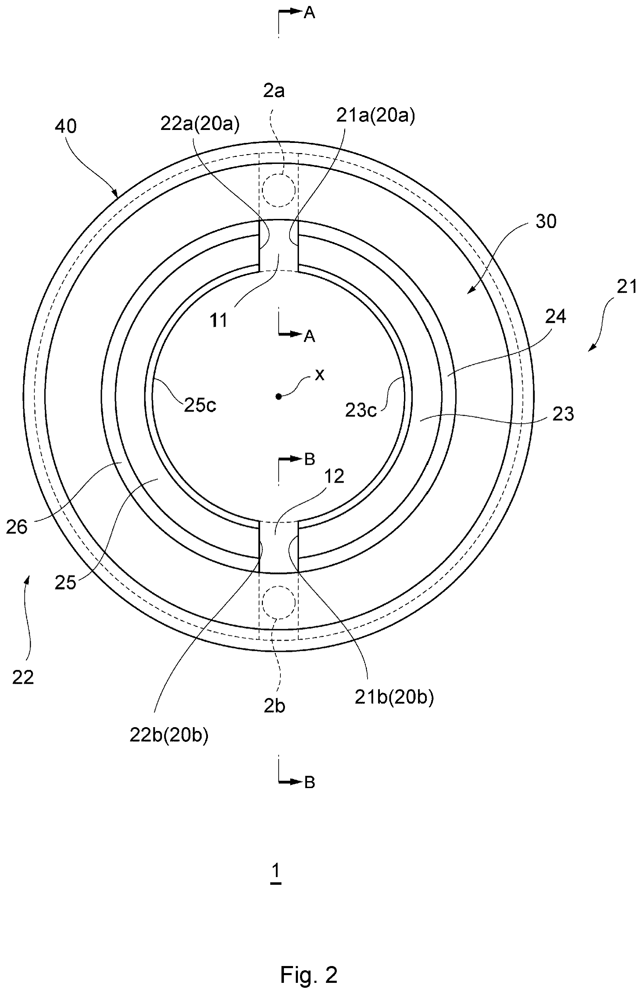

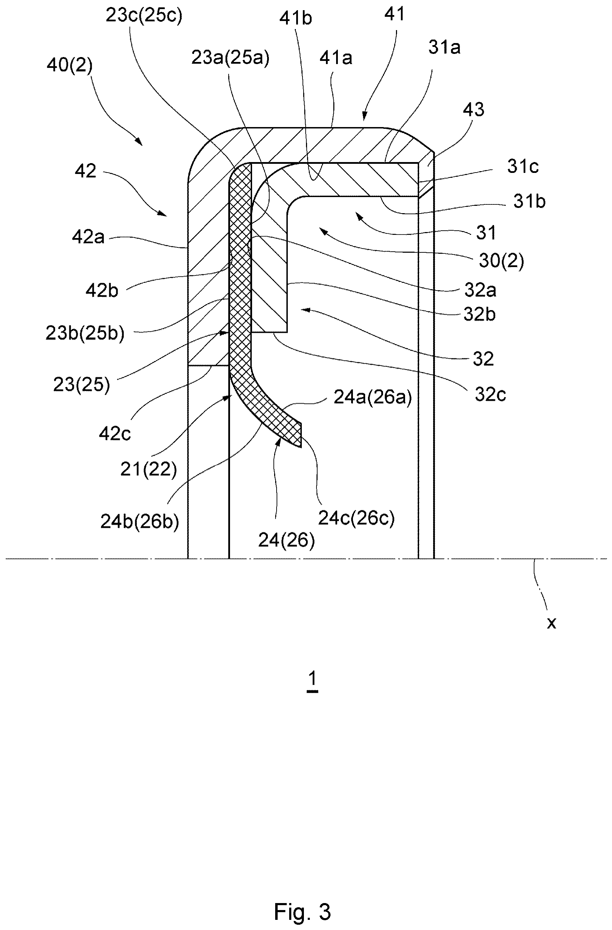

An electrically conductive structure according to an embodiment of the present invention forms an electrically conductive path at a rotating shaft and, for example, forms an electrically conductive path between the shaft and a hole where the shaft is inserted. It should be noted that an installation object that is to be installed with the electrically conductive structure according to the embodiment of the present invention is not limited to the above. Fig. 1 is a perspective view illustrating a schematic configuration of an electrically conductive structure 1 according to a first embodiment of the present invention, Fig. 2 is a front view of the electrically conductive structure 1 illustrated in Fig. 1, and Fig. 3 is a cross-sectional view illustrating one side with respect to an axis x in a cross section defined by a plane including the axis x of the electrically conductive structure 1.

As illustrated in Figs. 1 to 3, the electrically conductive structure 1 includes a holding member 2 that is an annular member with electrical conductivity around an axis x and an electrically conductive member 3 that is an annular member around the axis x. The electrically conductive member 3 has at least one gap 10 formed to extend in a radial direction and includes at least one electrical conductor 20 with electrical conductivity extending around the axis x. The electrically conductive member 3 is held by the holding member 2. The electrical conductor 20 has a pair of ends 20a, 20b in a direction around the axis x. The gap 10 is continuous with the ends 20a, 20b of the electrical conductor 20. A specific description will be made below on a configuration of the electrically conductive structure 1.

The electrically conductive member 3 has two gaps 10 and includes two electrical conductors 20 as illustrated in, for example, Figs. 1 to 3. Specifically, the electrically conductive member 3 has gaps 11, 12, which are the gaps 10, and includes electrical conductors 21, 22, which are the electrical conductors 20. The electrical conductors 21, 22, which have electrical conductivity, are made of a material with electrical conductivity. The material of the electrical conductors 20 (the electrical conductors 21, 22) is, for example, PTFE (polytetrafluoroethylene) with electrical conductivity. The material of the electrical conductors 20 is not limited to PTFE with electrical conductivity and may be, for example, another resin with electrical conductivity, a rubber with electrical conductivity, a fabric such as a nonwoven cloth with electrical conductivity, or the like.

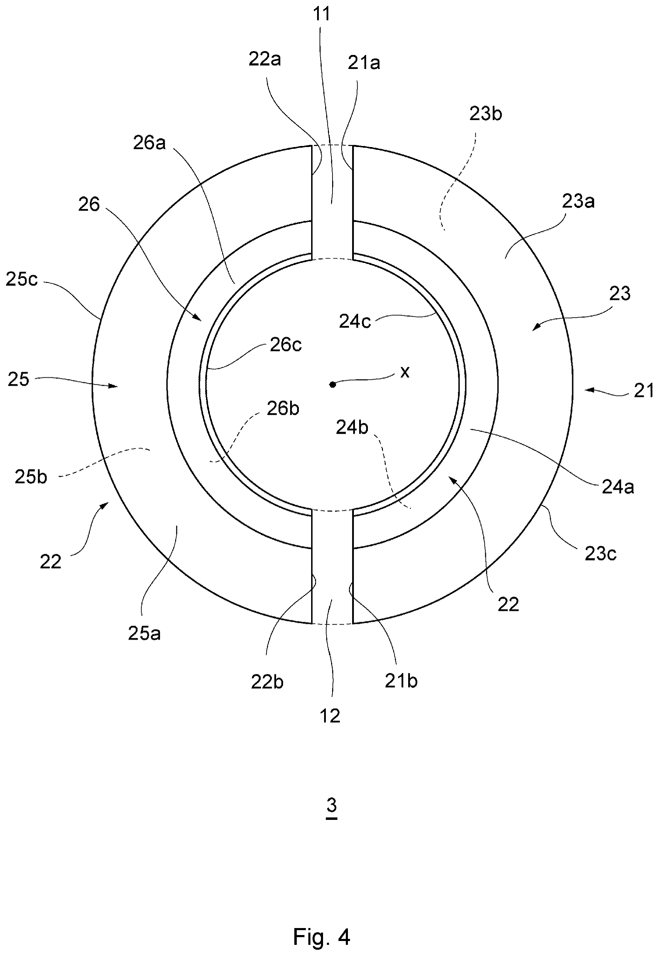

Fig. 4 is a front view of the electrically conductive member 3 of the electrically conductive structure 1. In the electrically conductive structure 1, the electrically conductive member 3 is in a form of an annular plate-shaped structure including the two gaps 10 (the gaps 11, 12) and the two electrical conductors 20 (the electrical conductors 21, 22) as illustrated in Figs. 1 to 4. As illustrated in Fig. 4, the electrical conductor 21 has a pair of ends 21a, 21b, which are the pair of ends 20a, 20b, and the electrical conductor 22 has a pair of ends 22a, 22b, which are the pair of ends 20a, 20b. One of the pair of ends (the end 21a) of one of the electrical conductors 20 (the electrical conductor 21) faces one of the pair of ends (22a) of the other one of the electrical conductors 20 (the electrical conductor 22) in the direction around the axis x (a circumferential direction). Moreover, the other one of the pair of ends (the end 21b) of the electrical conductor 21 faces the other one of the pair of ends (the end 21b) of the electrical conductor 22 in the direction around the axis x (the circumferential direction). One of the gaps 10 (the gap 11) is formed between the end 21a of the electrical conductor 21 and the end 22a of the electrical conductor 22 and the other one of the gaps 10 (the gap 12) is formed between the end 21b of the electrical conductor 21 and the end 22b of the electrical conductor 22.

As illustrated in Figs. 2 and 4, the electrical conductors 21, 22 are plate-shaped members extending along arcs around the axis x, for example, extending along or substantially along the arcs around or substantially around the axis x. Moreover, as illustrated in Fig. 3, the electrical conductor 21 includes a base 23, which is a portion extending along a plane, and a contact portion 24, which is a portion extending at a tilt in a direction of the axis x from the base 23.

As illustrated in Figs. 3 and 4, the base 23 is a plate-shaped portion and has side surfaces 23a, 23b, which are, for example, surfaces facing opposite sides to each other in the direction of the axis x. The side surface 23a extends along a plane perpendicular to the axis x and, for example, extends on a plane parallel or substantially parallel with the plane perpendicular to the axis x. Likewise, the side surface 23b extends along a plane perpendicular to the axis x and, for example, extends on a plane parallel or substantially parallel with the plane perpendicular to the axis x. It should be noted that the side surface 23a faces a front side (in Fig. 3, a right side with respect to the direction of the axis x). The side surface 23a and the side surface 23b extend so as to form an arc or substantially arc as illustrated in Fig. 4. Moreover, an edge on an outer peripheral side (an outer peripheral edge 23c) of the base 23 extends along a circle around the axis x.

As illustrated in Fig. 3, the contact portion 24 extends at a tilt from an edge on an inner peripheral side of the base 23 toward a side (the front side) where the side surface 23a of the base 23 faces. The contact portion 24 is a plate-shaped portion and has side surfaces 24a, 24b, which are, for example, surfaces facing opposite sides to each other. The contact portion 24 is in a shape reduced in diameter as approaching the front side in the direction of the axis x. The contact portion 24 is formed in a shape along an arc in a cross section defined by a plane including the axis x (hereinafter, simply referred to as "cross section") as illustrated in, for example, Fig. 3. Specifically, for example, the side surface 24a is, in cross section, in or substantially in an arc projecting toward the inner peripheral side as illustrated in Fig. 3. Likewise, the side surface 24b is in or substantially in an arc projecting toward the inner peripheral side. The side surface 24a is connected with the side surface 23a of the base 23 and the side surface 24b is connected with the side surface 23b of the base 23. Moreover, an edge on the inner peripheral side (an inner peripheral edge 24c) of the contact portion 24 extends along a circle around the axis x and, for example, extends on or substantially on a circle around or substantially around the axis x.

The contact portion 24, in a use state where the electrically conductive structure 1 is attached to an installation object, is configured to come into contact with an outer peripheral surface of a shaft of the installation object at an edge portion on the inner peripheral side of the contact portion 24 portion. Specifically, a diameter of the inner peripheral edge 24c of the contact portion 24 is set corresponding to a diameter of the outer peripheral surface of the shaft of the installation object and is, for example, the same as or smaller than the diameter of the outer peripheral surface of the shaft. For example, the electrical conductor 21 has a uniform or substantially uniform thickness in cross section as illustrated in Fig. 3. It should be noted that the thickness of the electrical conductor 21 is, in the base 23, a distance between the side surface 23a and the side surface 23b and, in the contact portion 24, a distance between the side surface 24a and the side surface 24b. It should be noted that the electrical conductor 21 does not necessarily have the uniform thickness.

As illustrated in Figs. 3 and 4, the electrical conductor 21 extends in the circumferential direction such that it becomes shorter than a half of the circle along which the electrical conductor 21 extends. That is to say, the electrical conductor 21 extends in the circumferential direction without the end 21a and the end 21b of the electrical conductor 21 being located on a single plane including the axis x or over the single plane including the axis x. As illustrated in Fig. 4, the ends 21a, 21b of the electrical conductor 21, for example, extend in parallel with or substantially in parallel with the plane including the axis x and are opposed in a direction perpendicular to the axis x. It should be noted that the ends 21a, 21b of the electrical conductor 21 do not necessarily extend in parallel with the plane including the axis x.

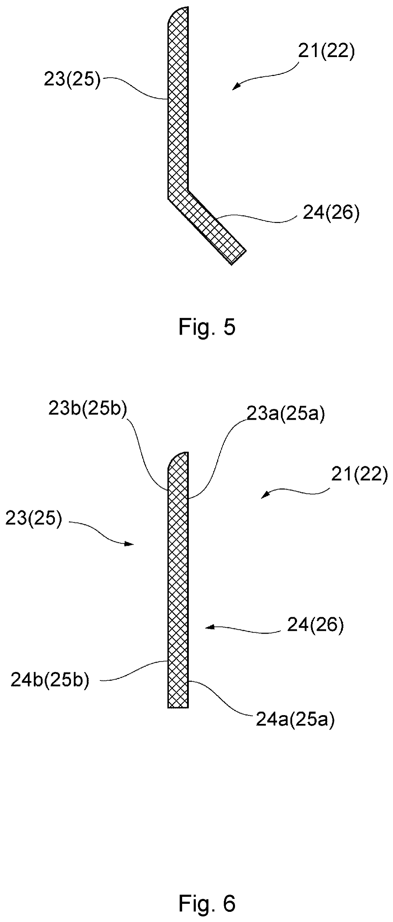

It should be noted that the cross-sectional shape of the electrical conductor 21 is not limited to the above-described cross-sectional shape and a variety of cross-sectional shapes are possible. For example, as illustrated in Fig. 5, the contact portion 24 of the electrical conductor 21 may have a shape extending along a conical surface around the axis x. Alternatively, for example, as illustrated in Fig. 6, the contact portion 24 of the electrical conductor 21 may not be tilted with respect to the base 23 with the side surface 23a being flush with the side surface 24a and the side surface 23b being flush with the side surface 24b. Alternatively, the contact portion 24 of the electrical conductor 21 may be, in cross section, in a shape extending along another curve or a shape extending along a line of a combination of a curve and a straight line.

Similarly to the electrical conductor 21, the electrical conductor 22 includes a base 25 and a contact portion 26 as illustrated in Figs. 3 and 4. The electrical conductor 22 is formed similarly to the electrical conductor 21 and is in or substantially in the same form as the electrical conductor 21. The ends 22a, 22b of the electrical conductor 22 correspond to the ends 21a, 21b of the electrical conductor 21. The base 25 and the contact portion 26 of the electrical conductor 22 correspond to the base 23 and the contact portion 24 of the electrical conductor 21, respectively. A side surface 25a, a side surface 25b, and an outer peripheral edge 25c of the base 25 of the electrical conductor 22 correspond to the side surface 23a, the side surface 23b, and the outer peripheral edge 23c, respectively, and a side surface 26a, a side surface 26b, and an inner peripheral edge 26c of the contact portion 26 of the electrical conductor 22 correspond to the side surface 24a, the side surface 24b, and the inner peripheral edge 24c of the contact portion 24 of the electrical conductor 21, respectively. It should be noted that the electrical conductor 22 is not necessarily formed similarly to the electrical conductor 21 and is not necessarily in or substantially in the same form as the electrical conductor 21.

As illustrated in Figs. 2 and 4, the electrical conductors 21, 22 and the gaps 11, 12, which are the components of the electrically conductive member 3 of the electrically conductive structure 1, are located on or substantially on the circle around or substantially around the axis x. Specifically, for example, the electrical conductor 21 and the electrical conductor 22 are symmetrically disposed with respect to the plane including the axis x. Moreover, the electrical conductor 21 and the electrical conductor 22 are disposed in a manner such that the inner peripheral edge 24c of the contact portion 24 of the electrical conductor 21 and the inner peripheral edge 26c of the contact portion 26 of the electrical conductor 22 are positioned on a circle or a substantially circular path centered or substantially centered about the axis x. The end 21a of the electrical conductor 21 and the end 22a of the electrical conductor 22 face each other in the direction perpendicular to the axis x and the end 21b of the electrical conductor 21 and the end 22b of the electrical conductor 22 face each other in the direction perpendicular to the axis x. This causes the gap 11 to be formed between the end 21a of the electrical conductor 21 and the end 22a of the electrical conductor 22 and the gap 12 to be formed between the end 21b of the electrical conductor 21 and the end 22b of the electrical conductor 22. As seen from the above, the gap 11 is continuous with the end 21a of the electrical conductor 21 and the end 22a of the electrical conductor 22 and the gap 12 is continuous with the end 21b of the electrical conductor 21 and the end 22b of the electrical conductor 22.

Specifically, the holding member 2 includes an internal holding member 30 located inside and an external holding member 40 located outside as illustrated in Figs. 1 to 3. The internal holding member 30 and the external holding member 40, which are annular members around the axis x, are configured to be able to hold the electrically conductive member 3 in between.

As illustrated in Fig. 3, the internal holding member 30 includes, for example, a fitting portion 31, which is an annular portion around the axis x, and a holding portion 32, which is an annular portion around the axis x. The fitting portion 31 is a cylindrical portion extending along the axis x and the holding portion 32 is a ring-shaped portion extending from an edge portion of the fitting portion 31 toward the inner peripheral side.

As illustrated in Fig. 3, the fitting portion 31 has, for example, an outer peripheral surface 31a and an inner peripheral surface 31b, which are surfaces facing opposite sides to each other in the radial direction perpendicular to the direction of the axis x, and has a rectangular or substantially rectangular cross-sectional shape. The outer peripheral surface 31a is a surface facing the outer peripheral side and the inner peripheral surface 31b is a surface facing the inner peripheral side. The outer peripheral surface 31a is a cylindrical surface extending along the axis x, for example, a round cylindrical or substantially round cylindrical surface around or substantially around the axis x. Likewise, the inner peripheral surface 31b is a cylindrical surface extending along the axis x, for example, a round cylindrical or substantially round cylindrical surface around or substantially around the axis x.

As illustrated in Fig. 3, the holding portion 32 has, for example, side surfaces 32a, 32b, which are surfaces facing opposite sides to each other in the direction of the axis x, and has a rectangular or substantially rectangular cross-sectional shape. The side surface 32a extends along a plane perpendicular to the axis x and, for example, extends on a plane parallel or substantially parallel with the plane perpendicular to the axis x. Likewise, the side surface 32b extends along a plane perpendicular to the axis x and, for example, extends on a plane parallel or substantially parallel with the plane perpendicular to the axis x. The side surfaces 32a, 32b extend along a circle around the axis x as illustrated in Figs. 2 and 3. The side surface 32a is connected with the outer peripheral surface 31a of the fitting portion 31 and the side surface 32b is connected with the inner peripheral surface 31b of the fitting portion 31.

As illustrated in Fig. 3, the external holding member 40 includes, for example, a fitting portion 41, which is an annular portion around the axis x, and a holding portion 42, which is an annular portion around the axis x. The fitting portion 41 is a cylindrical portion extending along the axis x and the holding portion 42 is a ring-shaped portion extending from an edge portion of the fitting portion 41 toward the inner peripheral side.

As illustrated in Fig. 3, the fitting portion 41 has, for example, an outer peripheral surface 41a and an inner peripheral surface 41b facing opposite sides to each other in the direction of the axis x and has a substantially rectangular cross-sectional shape. The outer peripheral surface 41a is a surface facing the outer peripheral side and the inner peripheral surface 41b is a surface facing the inner peripheral side. The outer peripheral surface 41a is a cylindrical surface extending along the axis x, for example, a round cylindrical or substantially round cylindrical surface around or substantially around the axis x. Likewise, the inner peripheral surface 31b is a cylindrical surface extending along the axis x, for example, a round cylindrical or substantially round cylindrical surface around or substantially around the axis x. Moreover, as illustrated in Fig. 3, an edge portion on the front side of the fitting portion 41 is provided with a retaining portion 43, which is a projecting portion projecting toward the inner peripheral side. Specifically, the retaining portion 43 projects from the inner peripheral surface 41b toward the inner peripheral side. The retaining portion 43 annularly extends around the axis x as illustrated in, for example, Figs. 1 and 3. It should be noted that the retaining portion 43 does not necessarily annularly continuously extend around the axis x and may annularly intermittently extend around the axis x. The retaining portion 43 may be formed by, for example, projecting portions extending in an arc along a circle around the axis x and that are intermittently arranged.

As illustrated in Fig. 3, the holding portion 42 has, for example, side surfaces 42a, 42b, which are surfaces facing opposite sides to each other in the direction of the axis x, and has a rectangular or substantially rectangular cross-sectional shape. The side surface 42a extends along a plane perpendicular to the axis x and, for example, extends on a plane parallel or substantially parallel with the plane perpendicular to the axis x. Likewise, the side surface 42b extends along a plane perpendicular to the axis x and, for example, extends on a plane parallel or substantially parallel with the plane perpendicular to the axis x. The side surfaces 42a, 42b extend along a circle around the axis x. The side surface 42a is connected with the outer peripheral surface 41a of the fitting portion 41 and the side surface 42b is connected with the inner peripheral surface 41b of the fitting portion 41.

As illustrated in Fig. 3, the fitting portion 31 of the internal holding member 30 and the fitting portion 41 of the external holding member 40 are configured to be fitted to each other. Specifically, for example, the outer peripheral surface 31a of the fitting portion 31 of the internal holding member 30 and the inner peripheral surface 41b of the fitting portion 41 of the external holding member 40 are configured to come into contact with each other. For example, a diameter of the outer peripheral surface 31a of the fitting portion 31 is larger than a diameter of the inner peripheral surface 41b of the fitting portion 41 and the outer peripheral surface 31a of the fitting portion 31 and the inner peripheral surface 41b of the fitting portion 41 are to be pressed in the radial direction against each other. It should be noted that the diameter of the outer peripheral surface 31a of the fitting portion 31 may be the same as the diameter of the inner peripheral surface 41b of the fitting portion 41 or may be smaller than the diameter of the inner peripheral surface 41b of the fitting portion 41.

Moreover, as illustrated in Fig. 3, in a state where the fitting portion 31 of the internal holding member 30 and the fitting portion 41 of the external holding member 40 are fitted to each other, the side surface 32a of the holding portion 32 of the internal holding member 30 and the side surface 42b of the holding portion 42 of the external holding member 40 have portions facing each other in the direction of the axis x. In the illustrated example, in the state where the fitting portion 31 and the fitting portion 41 are fitted to each other, the whole or substantially the whole of the surface 32a of the holding portion 32 faces a part of the side surface 42b of the holding portion 42 in the direction of the axis x. That is to say, a diameter of an edge 32c of the holding portion 32 is larger than a diameter of an edge 42c of the holding portion 42 and the edge 32c of the holding portion 32 is located on the outer peripheral side in the radial direction with respect to the edge 42c of the holding portion 42. It should be noted that the diameter of the edge 32c of the holding portion 32 may be the same as the diameter of the edge 42c of the holding portion 42. Alternatively, the diameter of the edge 32c of the holding portion 32 may be smaller than the diameter of the edge 42c of the holding portion 42 and the edge 32c of the holding portion 32 may be located on the inner peripheral side in the radial direction with respect to the edge 42c of the holding portion 42.

Moreover, as illustrated in Fig. 3, in the state where the fitting portion 31 of the internal holding member 30 and the fitting portion 41 of the external holding member 40 are fitted to each other, the side surface 32a of the holding portion 32 of the internal holding member 30 and the side surface 42b of the holding portion 42 of the external holding member 40 face the respective bases 23, 25 of the electrical conductors 21, 22 in the direction of the axis x. In the illustrated example, in the state where the fitting portion 31 and the fitting portion 41 are fitted to each other, the whole or substantially the whole of the side surface 32a of the holding portion 32 and the whole or substantially the whole of the side surface 42b of the holding portion 42 face the respective bases 23, 25 of the electrical conductors 21, 22 in the direction of the axis x.

Moreover, as illustrated in Fig. 3, in a state where the outer peripheral surface 31a of the fitting portion 31 of the internal holding member 30 is in contact with the inner peripheral surface 41b of the fitting portion 41 of the external holding member 40 and the retaining portion 43 of the fitting portion 41 is in contact with an edge 31c of the fitting portion 31 in the direction of the axis x (hereinafter, also referred to as "assembled state"), a gap is formed between the side surface 32a of the holding portion 32 and the side surface 42b of the holding portion 42. A width in the direction of the axis x of the gap, that is, a width in the direction of the axis x between the side surface 32a of the holding portion 32 and the side surface 42b of the holding portion 42 in the assembled state, is larger than, for example, a thickness of the respective bases 23, 25 of the electrical conductors 21, 22. This makes it possible to sandwich the respective bases 23, 25 of the electrical conductors 21, 22 in between the holding portion 32 and the holding portion 42 in the assembled state of the internal holding member 30 and the external holding member 40. Moreover, in the assembled state of the internal holding member 30 and the external holding member 40, it is possible to press-sandwich the respective bases 23, 25 of the electrical conductors 21, 22 in between the holding portion 32 and the holding portion 42 in the direction of the axis x and, consequently, firmly sandwich the electrical conductors 21, 22.

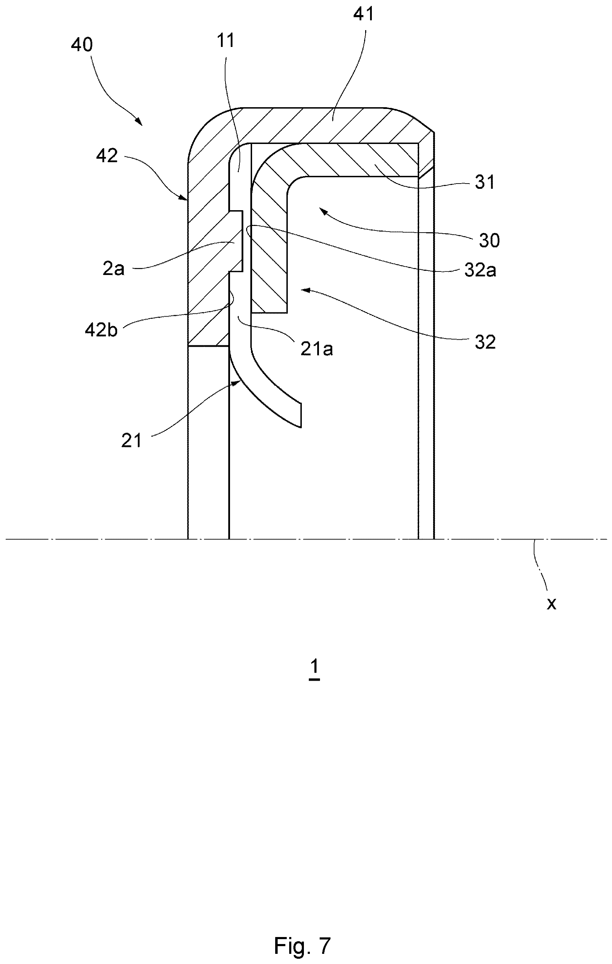

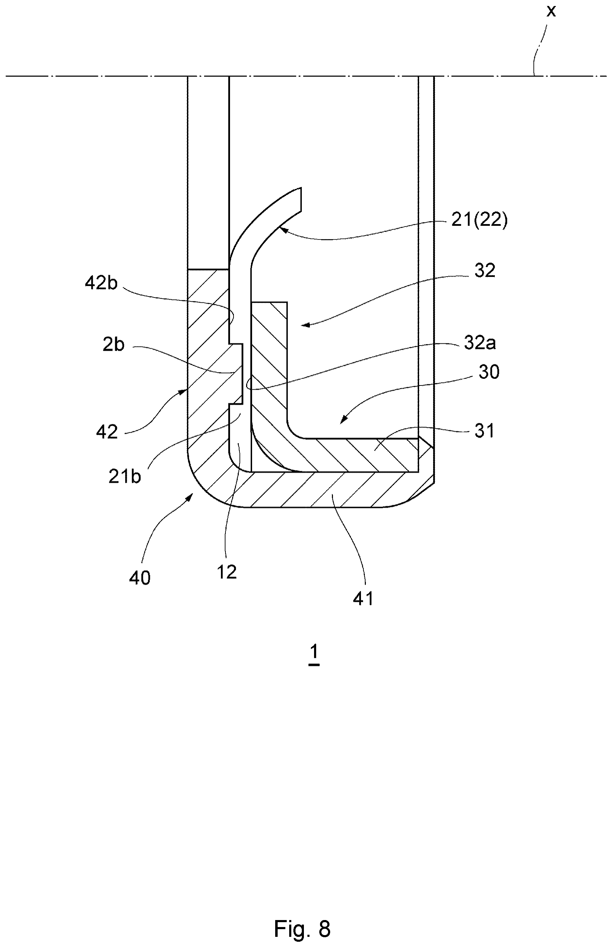

The side surface 42b of the holding portion 42 of the external holding member 40 is provided with projections 2a, 2b, which are portions projecting toward the front side, at respective positions in the circumferential direction corresponding to the gaps 11, 12 of the electrically conductive member 3 as illustrated in, for example, Figs. 2, 7, and 8. It should be noted that Fig. 7 is a cross-sectional view of a cross section along a line A-A in Fig. 2 and Fig. 8 is a cross-sectional view of a cross section along a line B-B in Fig. 2. In the electrically conductive structure 1, the projection 2a is housed in the gap 11 and the projection 2b is housed in the gap 12. In the gap 11, the projection 2a is configured to come into contact with the end 21a of the electrical conductor 21 and the end 22a of the electrical conductor 22. In the gap 12, the projection 2b is configured to come into contact with the end 21b of the electrical conductor 21 and the end 22b of the electrical conductor 22. It should be noted that in the gap 11, a gap may be formed between the projection 2a and the end 21a of the electrical conductor 21. Moreover, in the gap 11, a gap may be formed between the projection 2a and the end 22a of the electrical conductor 22. Likewise, in the gap 12, a gap may be formed between the projection 2b and the end 21b of the electrical conductor 21. Moreover, in the gap 12, a gap may be formed between the projection 2b and the end 22b of the electrical conductor 22. It should be noted that the projections 2a, 2b may be provided not on the side surface 42b of the holding portion 42 of the external holding member 40 but on the side surface 32a of the holding portion 32 of the internal holding member 30 in a manner such that the projections 2a, 2b are likewise housed in the gaps 11, 12, respectively. Moreover, the projections 2a, 2b may also be provided on the side surface 32a of the holding portion 32 of the internal holding member 30 in addition to the side surface 42b of the holding portion 42 of the external holding member 40. Moreover, a plurality of projections 2a may be provided. Moreover, a plurality of projections 2b may be provided.

The internal holding member 30 is integrally formed of the same material and the fitting portion 31 and the holding portion 32, which are the portions of the integrally formed internal holding member 30, are integrally connected. Likewise, the external holding member 40 is integrally formed of the same material and the fitting portion 41 and the holding portion 42, which are the portions of the integrally formed external holding member 40, are integrally connected. Although made of a metal with electrical conductivity, the internal holding member 30 and the external holding member 40 may be integrally formed of another material with electrical conductivity.

The component members of the electrically conductive structure 1, which have the configurations as described above, are assembled into the assembled state, serving as the electrically conductive structure 1 as illustrated in Fig. 3. In the electrically conductive structure 1, the fitting portion 31 of the internal holding member 30 is fitted to the fitting portion 41 of the external holding member 40 and the fitting portion 31 of the internal holding member 30 is pressed toward a back side opposite the front side by the retaining portion 43 of the fitting portion 41 of the external holding member 40. Moreover, the electrical conductors 21, 22 are sandwiched between the holding portion 32 of the internal holding member 30 and the holding portion 42 of the external holding member 40. The electrical conductors 21, 22 are held by the internal holding member 30 and the external holding member 40 on the outer peripheral side. As seen from the above, the internal holding member 30 is fixed to the external holding member 40 and the electrical conductors 21, 22 are fixed between the internal holding member 30 and the external holding member 40. Moreover, the electrical conductors 21, 22 are attached to the internal holding member 30 and the external holding member 40 with the respective contact portions 24, 26 projecting toward the front side. It should be noted that the electrical conductors 21, 22 may be attached to the internal holding member 30 and the external holding member 40 in a manner such that the respective contact portions 24, 26 project toward the back side.

Before put into the assembled state as illustrated in Fig. 3, the fitting portion 41 of the external holding member 40 may include no retaining portion 43. For example, the retaining portion 43 may be formed in the fitting portion 41 after the electrically conductive member 3 is attached to the external holding member 40 with no retaining portion 43 formed in the fitting portion 41 and then the fitting portion 31 of the internal holding member 30 is attached to the fitting portion 41 of the external holding member 40. That is to say, the fitting portion 31 and the fitting portion 41 may be crimped by forming the retaining portion 43 so that the edge 31c of the fitting portion 31 is pressed toward the back side in the direction of the axis x by the retaining portion 43 to put the electrically conductive member 3, the internal holding member 30, and the external holding member 40 into the assembled state as illustrated in Fig. 3.

Moreover, in the assembled state as illustrated in Fig. 3, the projections 2a, 2b formed on the holding portion 42 of the external holding member 40 are housed in the gaps 11, 12 of the electrically conductive member 3 and in contact with the ends 21a, 21b of the electrical conductor 21 and the ends 22a, 22b of the electrical conductor 22, respectively.

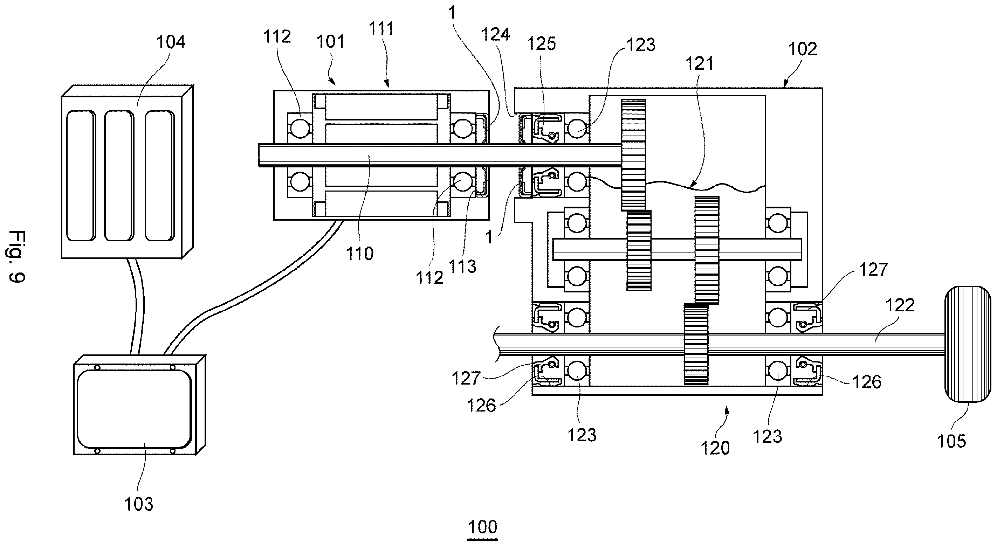

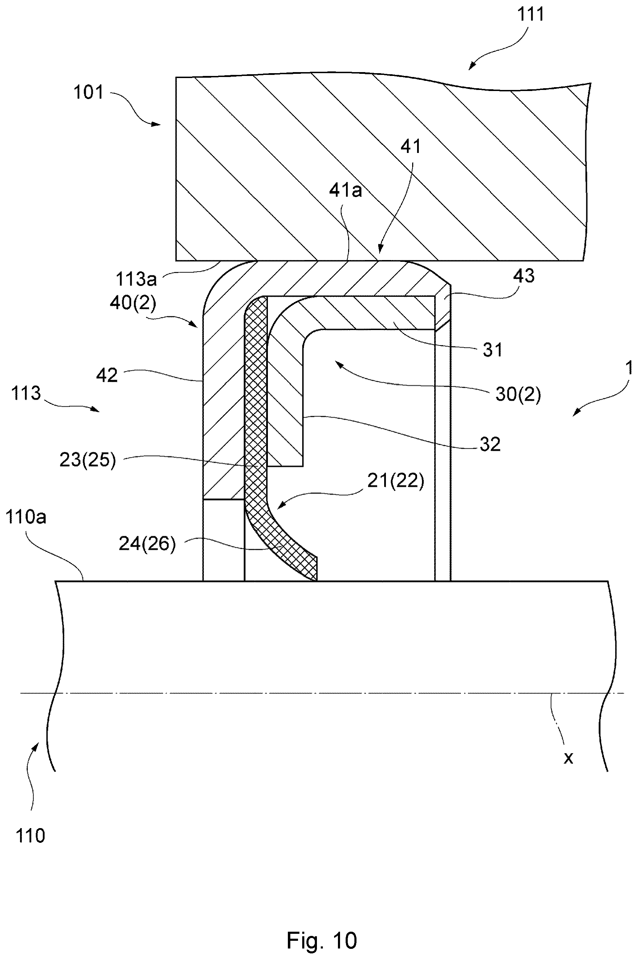

Next, description will made on the workings of the electrically conductive structure 1. Fig. 9 is a schematic diagram for illustrating an example of an installation object of the electrically conductive structure 1. Fig. 10 is a cross-sectional view illustrating an example of the use state of the electrically conductive structure 1 in the installation object illustrated in Fig. 9. The electrically conductive structure 1 is installed in, by way of example, a drive device 100 of a battery electric vehicle (BEV) as illustrated in Fig. 9. The drive device 100 includes an electric motor 101, a decelerator 102, an inverter 103 that controls the electric motor 101, a battery 104, which is a power source, as illustrated in, for example, Fig. 9. A shaft 110 of the electric motor 101 is rotatably supported by a bearing 112 supported in a housing 111 and projects outside the housing 111 through a shaft hole 113 of the housing 111. The shaft 110 of the electric motor 101 enters a housing 120 through a shaft hole 124 of the housing 120 of the decelerator 102 and is rotatably supported by a bearing 123 supported in the housing 120. Moreover, the shaft 110 is coupled to a reduction gear stage 121 in the housing 120. Moreover, the decelerator 102 is provided with a shaft 122 that outputs a rotary drive force reduced by the reduction gear stage 121. The shaft 122 is also rotatably supported by the bearing 123 supported in the housing 120, while being coupled to a wheel 105 so as to be able to transmit the rotary drive force to the wheel 105. The shaft hole 124 of the housing 120 of the decelerator 102 is attached with an oil seal 125 for sealing a gap between the shaft hole 124 and the shaft 110 of the electric motor 101. A shaft hole 126 of the housing 120 where the shaft 122 of the decelerator 102 is inserted is attached with an oil seal 127 for sealing a gap between the shaft hole 126 and the shaft 122. It should be noted that the shaft 110 and the housing 111 of the electric motor 101 are made of metal and the housing 120 and the shaft 122 of the decelerator 102 are made of metal.

The electrically conductive structure 1 is put in the use state by, by way of example, being provided between the housing 111 and the shaft 110 of the electric motor 101. Specifically, the electrically conductive structure 1 is put in the use state by fit-attaching the fitting portion 41 of the external holding member 40 of the holding member 2 to the shaft hole 113 of the housing 111 to fix the electrically conductive structure 1 to the shaft hole 113 and inserting the shaft 110 into the electrically conductive member 3 as illustrated in Fig. 10. In the use state, the inner peripheral edges 24c, 26c of the electrical conductors 21, 22 of the electrically conductive member 3 are in contact with an outer peripheral surface 110a of the shaft 110. Moreover, the holding member 2 (the internal holding member 30 and the external holding member 40), which is attached with the electrically conductive member 3, is made of a metal with electrical conductivity and in contact with an inner peripheral surface 113a of the shaft hole 113 of the housing 111. As seen from the above, the electrically conductive member 3 and the holding member 2 form an electrically conductive path for electricity to flow between the shaft 110 and the housing 111 of the electric motor 101 in the use state.

Moreover, the electrically conductive structure 1 may be provided between the housing 120 of the decelerator 102 and the shaft 110. Specifically, the electrically conductive structure 1 may be provided on an outer side of the oil seal 125 and in a gap between the shaft hole 124 of the housing 120 and the shaft 110 as illustrated in Fig. 9. In this case, the electrically conductive member 3 and the holding member 2 of the electrically conductive structure 1 also form an electrically conductive path for electricity to flow between the shaft 110 of the electric motor 101 and the housing 120 of the decelerator 102 as the electrically conductive structure 1 attached to the electric motor 101. Moreover, the electrically conductive structure 1 may likewise be provided on an outer side of the oil seal 127 and in a gap between the shaft hole 126 and the shaft 122 of the housing 120.

It should be noted that the above-described drive device 100 is an example of the installation object of the electrically conductive structure 1 and the installation object of the electrically conductive structure 1 is not limited thereto. The electrically conductive structure 1 is usable in, for example, a drive device for an electric vehicle (EV), such as a hybrid vehicle (HV) or a fuel cell vehicle (FCV), or the like in addition to a battery electric vehicle (BEV). There are cases where a vehicle equipped with an electric motor, such as an electric vehicle (EV), suffers the generation of an electromagnetic noise due to an induced current generated by the motor, or the like. Moreover, there are cases where an electromagnetic noise occurs due to an on/off operation of an inverter for a control of an electric current to be supplied to a motor such as an electric motor, an induced voltage of the motor itself, or the like. As described above, the electrically conductive structure 1 forms the electrically conductive path to cause the electromagnetic noise transmitted to the shaft 110 to flow into the housings 111, 120. This makes it possible to prevent the occurrence of a communication failure or a malfunction of electronic equipment and the occurrence of electrolytic corrosion of a metal part such as a bearing.

The electrical conductors 21, 22 of the electrically conductive member 3, which are in contact with the shaft 110, are made of PTFE and high in heat resistance performance and wear resistance performance. Accordingly, it is not necessary to provide a lubricant with electrical conductivity between the electrical conductors 21, 22 and the shaft 110 in order to reduce wear or fatigue of the electrical conductors 21, 22. Thus, there is no lubricant, which is likely to become a resistance to an electrically conductive path, in the electrically conductive paths between the shaft 110 and the housings 111, 120, which enables, in the use state, reducing a decrease in electrically conductive performance of the electrically conductive structure 1.

Moreover, in the electrically conductive member 3, the electrical conductors 21, 22 are annularly disposed side by side with the gaps 11, 12 in between. Thus, even though an external force is applied to the electrical conductors 21, 22 by a rotation of the shaft 110 in the use state, the electrical conductors 21, 22 are able to retreat into the gaps 11, 12, which makes it possible to reduce, in the electrical conductors 21, 22, the occurrence of a deformation or a contact with the shaft 110 likely to lead to the occurrence of stress concentration. This makes it possible to reduce wear or fatigue of the electrical conductors 21, 22. From this point of view, the electrically conductive structure 1 makes it possible to eliminate the necessity of providing a lubricant with electrical conductivity between the electrical conductors 21, 22 and the shaft 110.

Moreover, it is possible to attach the electrically conductive structure 1 around the shaft 110 by fit-attaching the holding member 2 to the shaft hole 113 of the housing 111. As seen from the above, the attachment of the electrically conductive structure 1 only requires an annular space surrounding the outer peripheral surface 110a of the shaft 110. In a case where there is a space for the electrically conductive structure 1 to be attached between the outer peripheral surface 110a of the shaft 110 and the inner peripheral surface 113a of the shaft hole 113, the electrically conductive structure 1 is attachable in the shaft holes 113, 124 and, accordingly, it is not necessary to make an additional space for attaching the electrically conductive structure 1 in the housing 111. Moreover, even in a case where there is no space for the electrically conductive structure 1 to be attached between the outer peripheral surface 110a of the shaft 110 and the inner peripheral surface 113a of the shaft hole 113, it is only necessary to make a small annular space at the inner peripheral surface 113a of the shaft hole 113 in order to attach the electrically conductive structure 1, as a cross section of the electrically conductive structure 1 is not large. As seen from the above, the electrically conductive structure 1 enables saving of space, since a space for the electrically conductive structure 1 to be attached can be reduced.

Moreover, in the electrically conductive member 3, the electrical conductors 21, 22 are annularly disposed side by side with the gaps 11, 12 in between. It is thus possible for the electrical conductors 21, 22 to retreat into the gaps 11, 12 in fixing the electrically conductive member 3 to the holding member 2. This makes it possible to reduce the occurrence of a deformation such as a crease in the electrical conductors 21, 22 in fixing the electrically conductive member 3 to the holding member 2.

Moreover, it is possible to produce a plurality of in-process products of the electrical conductors 21, 22, which are to be molded into the shape of the electrical conductors 21, 22, by cutting them from a material in a form of a single sheet. It is thus possible to efficiently manufacture the electrical conductors 21, 22 with an excellent yield.

Moreover, in the assembled state illustrated in Fig. 3, the projections 2a, 2b formed on the holding portion 42 of the external holding member 40 are housed in the gaps 11, 12 of the electrically conductive member 3 and in contact with the ends 21a, 21b of the electrical conductor 21 and the ends 22a, 22b of the electrical conductor 22, respectively. Thus, the electrical conductors 21, 22 do not rotate with respect to the holding member 2 with a rotation of the shaft 110.

Therefore, the electrically conductive structure 1 according to the first embodiment of the present invention enables saving of space and, in the use state, reducing a decrease in electrically conductive performance.

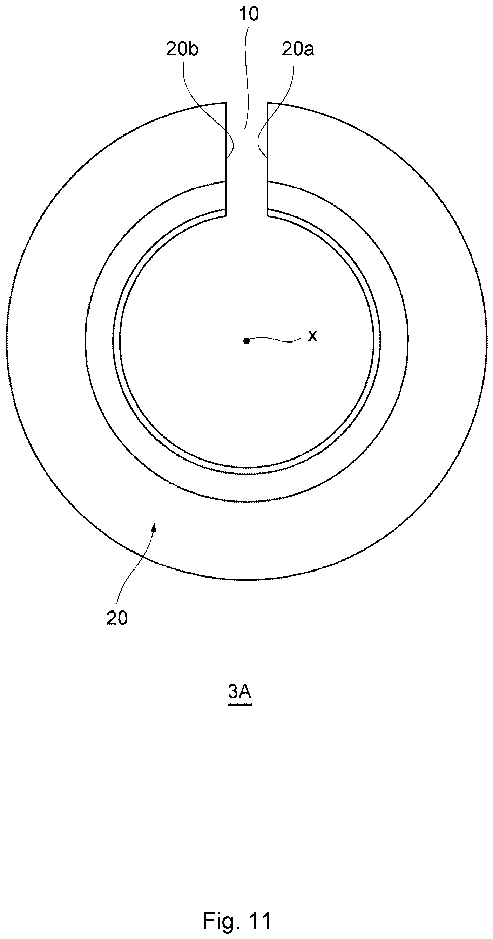

Next, description will be made on a modification example of the above-described electrically conductive member 3. Fig. 11 is a front view of an electrically conductive member 3A according to the modification example of the electrically conductive member 3. The electrically conductive member 3A includes a single electrical conductor 20 and has a single gap 10 as illustrated in Fig. 11. In the electrically conductive member 3A, one of the gap 11 and the gap 12 of the electrically conductive member 3 is absent and the electrical conductor 21 or the electrical conductor 22 also extends at a portion corresponding to the one of the gap 11 and the gap 12, causing the electrical conductor 21 and the electrical conductor 22 to be connected with the one of the gap 11 and the gap 12 at the portion corresponding to form into the single electrical conductor 20. The electrical conductor 20 of the electrically conductive member 3A according to the modification example extends, for example, on or substantially on a circle around or substantially around the axis x with the end 20a and the end 20b facing in the circumferential direction, specifically, for example, facing in a direction perpendicular to the axis x, as illustrated in Fig. 11. A cross-sectional shape of the electrical conductor 20 is the cross-sectional shape of the electrical conductor 21. It should be noted that the electrically conductive member 3 may include three or more gaps 10 and three or more electrical conductors 20. In this case, the plurality of gaps 10 and the plurality of electrical conductors 20 are also annularly continuous.

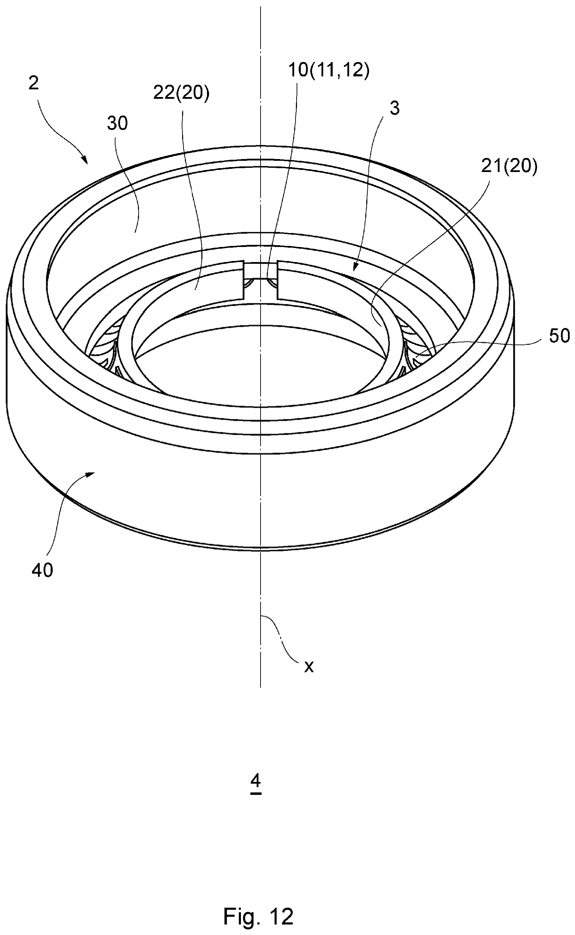

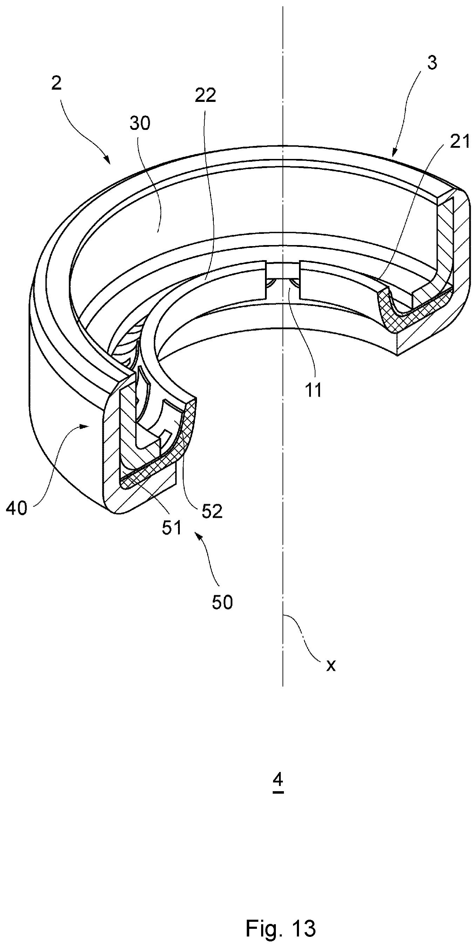

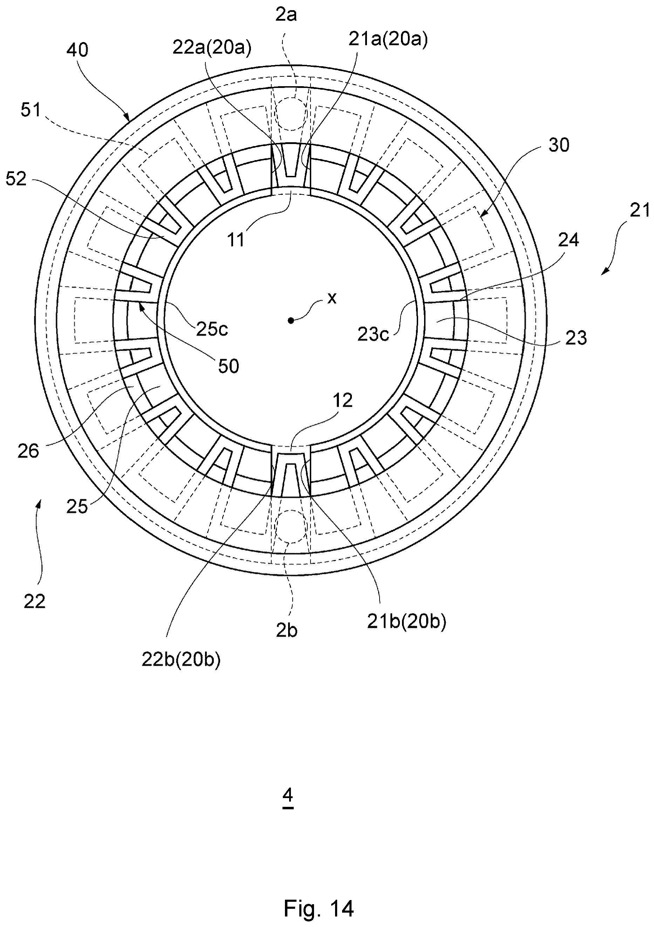

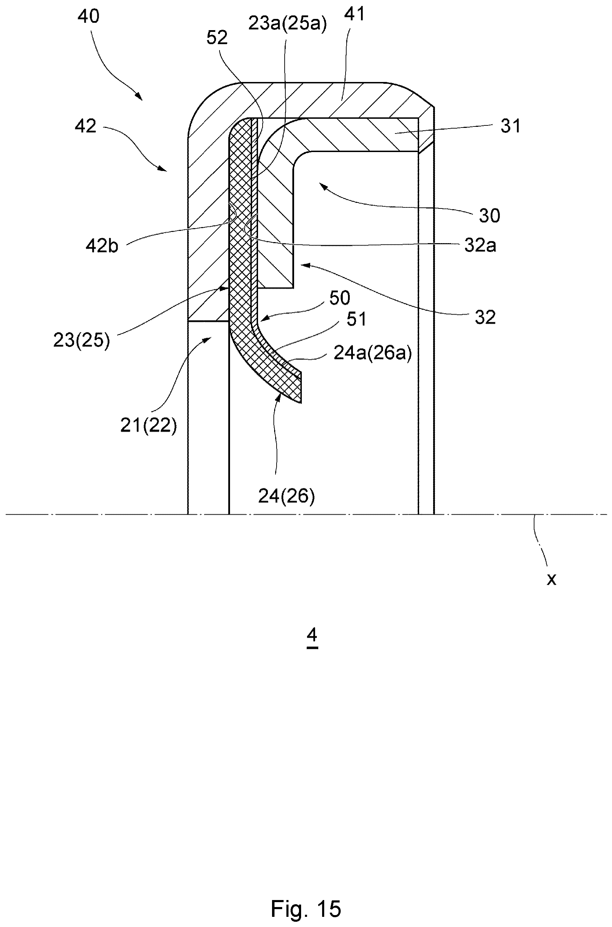

Next, description will be made on an electrically conductive structure 4 according to a second embodiment of the present invention. Fig. 12 is a perspective view illustrating a schematic configuration of the electrically conductive structure 4 and Fig. 13 is a cross-sectional perspective view with a partial cutaway of the electrically conductive structure 4 illustrated in Fig. 12. Moreover, Fig. 14 is a front view of the electrically conductive structure 4 illustrated in Fig. 11 and Fig. 15 is a cross-sectional view illustrating one side with respect to the axis x in a cross section defined by a plane including the axis x of the electrically conductive structure 4. The electrically conductive structure 4 according to the present embodiment is different form the above-described electrically conductive structure 1 mainly in that the electrically conductive structure 4 includes a spring member 50. As for components of the electrically conductive structure 4, a component having the same or similar configuration as or to the above-described electrically conductive structure 1 is labelled with the same reference sign and, accordingly, the description thereof is omitted, and a different component will be described below.

As described above, the electrically conductive structure 4 includes the spring member 50. As illustrated in Figs. 11 to 15, the spring member 50 is an annular spring member around the axis x and is configured to generate an elastic force in a direction toward the axis x. Moreover, the spring member 50 is configured to be disposed side by side with the electrically conductive member 3 in the direction of the axis x. It should be noted that the direction toward the axis x is not limited to a direction toward the inner peripheral side in the radial direction and only has to be a direction containing a directional component toward the inner peripheral side in the radial direction. Specifically, the spring member 50 is a ring-shaped leaf spring and is configured to be able to generate an elastic force that supports the contact portions 24, 26 in a manner such that the contact portions 24, 26 of the electrical conductors 21, 22 of the electrically conductive member 3 come into contact with the outer peripheral surface 110a (see Fig. 10) of the shaft 110. The spring member 50 is in a shape along the respective side surfaces 23a, 24a and side surfaces 25a, 26a of the electrical conductors 21, 22 as illustrated in, for example, Fig. 15. Moreover, the spring member 50 is sandwiched between the holding portion 32 of the internal holding member 30 and the bases 23, 25 of the electrical conductors 21, 22 to be fixed in the electrically conductive structure 4 as illustrated in Fig. 15 and the electrically conductive structure 4 is able to hold the spring member 50 in this manner. Specifically, in the assembled state of the internal holding member 30 and the external holding member 40, a distance in the direction of the axis x between the holding portion 32 and the holding portion 42 is set so that the base 23 of the electrical conductor 21 and a base 51 of the spring member 50 are press-sandwiched in the direction of the axis x and the base 25 of the electrical conductor 22 is press-sandwiched in the direction of the axis x.

As illustrated in, for example, Figs. 14 and 15, the spring member 50 includes the base 51 and a resilient portion 52. The base 51 is a portion sandwiched between the holding portion 32 of the internal holding member 30 and the respective bases 23, 25 of the electrical conductors 21, 22. The resilient portion 52, which is a portion that applies an elastic force toward the axis x to the respective contact portions 24, 26 of the electrical conductors 21, 22, is configured to come into contact with the respective side surfaces 24a, 26a of the respective contact portions 24, 26 of the electrical conductors 21, 22. The resilient portion 52 extends, for example, along a cylindrical surface reduced in diameter as approaching the front side in the direction of the axis x. A thickness of the spring member 50 is set in accordance with, for example, an elastic force to be applied to the respective contact portions 24, 26 of the electrical conductors 21, 22. Specifically, the spring member 50 is, for example, a leaf spring including a plurality of inwardly projecting spring pieces provided around the axis x as illustrated in Figs. 13 and 14. A specific form of the spring member 50 may be a different form. Moreover, the spring member 50 may extend in an ended annular shape instead of continuously extending in an endless annular shape or may include a plurality of spring members extending in an arc and that are intermittently annularly arranged. For example, instead of being in an endless annular shape as illustrated, the spring member 50 may include two spring members extending in an arc and that correspond to the respective electrical conductors 21, 22.

In the electrically conductive structure 4, the elastic force toward the axis x is to be exhibited with respect to the respective contact portions 24, 26 of the electrical conductors 21, 22 of the electrically conductive member 3 as described above. The electrical conductors 21, 22 are thus supported to be in contact with the outer peripheral surface 110a of the shaft 110 by the spring member 50. This reduces a failure of the electrical conductors 21, 22 to be in contact with the shaft 110 due to weakening or deformation of the electrical conductors 21, 22 with a change over time.

The electrically conductive structure 4 is also to be used as the above-described electrically conductive structure 1 to form an electrically conductive path. Moreover, the electrically conductive structure 4 also makes it possible to eliminate the necessity for a lubricant as the electrically conductive structure 1, so that it is possible to reduce, in the use state, a decrease in electrically conductive performance of the electrically conductive structure 1. Moreover, the electrically conductive structure 4 also enables saving of space, since a space for the electrically conductive structure 4 to be attached can be eliminated or reduced. Moreover, the electrically conductive structure 4 also makes it possible to reduce the occurrence of a deformation such as a crease in the electrical conductors 21, 22 in fixing the electrically conductive member 3 to the holding member 2. Moreover, it is also possible to efficiently manufacture the electrical conductors 21, 22 of the electrically conductive structure 4 with an excellent yield. Moreover, in the electrically conductive structure 4, the electrical conductors 21, 22 do not also rotate with respect to the holding member 2 with a rotation of the shaft 110.

Therefore, the electrically conductive structure 4 according to the second embodiment of the present invention enables saving of space and, in the use state, reducing a decrease in electrically conductive performance.

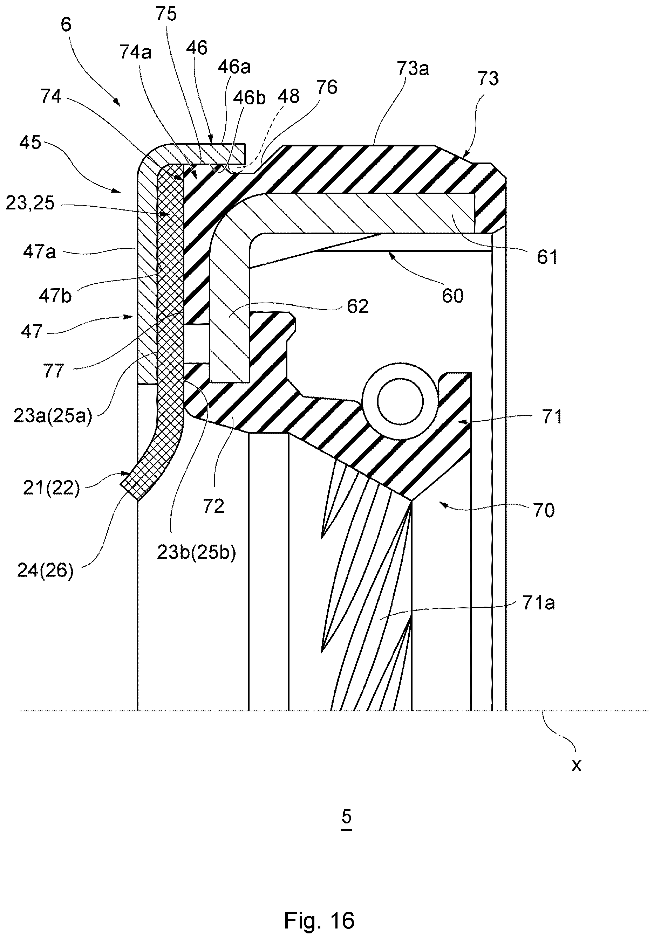

Next, description will be made on an electrically conductive sealing device 5 according to the first embodiment of the present invention. Fig. 16 is a cross-sectional view of a schematic configuration of the electrically conductive sealing device 5, illustrating one side with respect to the axis x in a cross section defined by a plane including the axis x of the electrically conductive sealing device 5. The electrically conductive sealing device 5 is a sealing device for achieving sealing between a shaft of an installation object and a hole where the shaft is inserted and is an electrically conductive structure that forms an electrically conductive path between the shaft and the hole where the shaft is inserted.

As illustrated in Fig. 16, the electrically conductive sealing device 5 includes a reinforcing ring 60, which is an annular member, around the axis x, an elastic body portion 70 made of an annular elastic body around the axis x attached to the reinforcing ring 60, and an annular electrically conductive structure 6 around the axis x. The elastic body portion 70 includes a seal lip 71 that comes into contact with the shaft. The electrically conductive structure 6 includes a holding member 7, which is an annular member around the axis x, and the electrically conductive member 3 (see Fig. 4), which is an annular member around the axis x. The electrically conductive member 3 has at least one gap 10 provided to extend in the radial direction and includes at least one electrical conductor 20 with electrical conductivity extending around the axis x. A holding member 45 is attached to the elastic body portion 70 with the electrical conductor 20 held between the holding member 45 and the elastic body portion 70. The electrical conductor 20 has the pair of ends 20a in a direction around the axis x and the gap 10 is continuous with the ends 20a, 20b of the electrical conductor 20. A specific description will be made below on a configuration of the electrically conductive sealing device 5.

As illustrated in Fig. 16, the electrically conductive sealing device 5 includes, for example, the reinforcing ring 60 and the elastic body portion 70 similar to those of a known oil seal and the reinforcing ring 60 includes a cylindrical portion 61 and a ring portion 62. The elastic body portion 70 also includes a base 72, a gasket portion 73, and a cover portion 74 in addition to the seal lip 71. The seal lip 71 extends from the base 72 toward a sealing-object side. The gasket portion 73 is a portion covering the cylindrical portion 61 of the reinforcing ring 60 from the outer peripheral side and a portion that is to be press-fitted in the hole of the installation object. An outer peripheral surface 73a of the gasket portion 73 has a diameter allowing for pressing against the hole of the installation object. The cover portion 74 is a portion covering the ring portion 62 of the reinforcing ring 60 from opposite the sealing-object side.

As illustrated in Fig. 16, a fitting surface 75, which is an annular surface facing the outer peripheral side, is formed in an edge portion on the outer peripheral side (an outer peripheral edge portion 74a) of the cover portion 74. The fitting surface 75 is, for example, a cylindrical surface extending along a round cylindrical plane around the axis x. The fitting surface 75 is, for example, a cylindrical surface extending along a round cylindrical plane around the axis x. Specifically, the fitting surface 75 is, for example, a round cylindrical or substantially round cylindrical surface around or substantially around the axis x. The fitting surface 75 is located on the outer peripheral side with respect to the other portions of the outer peripheral edge portion 74a as illustrated in, for example, Fig. 16 and an annular recess 76 recessed toward the inner peripheral side is formed between the fitting surface 75 and the gasket portion 73. The fitting surface 75 of the cover portion 74 is located on the inner peripheral side in the radial direction with respect to the outer peripheral surface 73a of the gasket portion 73.

The cover portion 74 also has a holding surface 77, which is an annular surface facing the opposite side to the sealing-object side. The holding surface 77 is, for example, a surface extending along a plane perpendicular to the axis x. Specifically, the holding surface 77 is, for example, a surface extending on a plane parallel or substantially parallel with a plane perpendicular to the axis x.

The electrically conductive structure 6 includes the holding member 45, which is similar to the external holding member 40 of the holding member 2 of the above-described electrically conductive structure 1, and the electrically conductive member 3 (see Fig. 4) of the above-described electrically conductive structure 1. The holding member 45 is made of the same electrically conductive material as the external holding member 40. As illustrated in Fig. 16, the holding member 45 includes, for example, a fitting portion 46, which is an annular portion around the axis x, and a holding portion 47, which is an annular portion around the axis x. The fitting portion 46 is a cylindrical portion extending along the axis x and the holding portion 47 is a ring-shaped portion extending from an edge portion of the fitting portion 46 toward the inner peripheral side. As illustrated in Fig. 16, the fitting portion 46 has, for example, an outer peripheral surface 46a and an inner peripheral surface 46b facing opposite sides to each other in the direction of the axis x and has a substantially rectangular cross-sectional shape. The outer peripheral surface 46a is an annular surface facing the outer peripheral side and the inner peripheral surface 46b is an annular surface facing the inner peripheral side. The inner peripheral surface 46b is a cylindrical surface extending along the axis x, for example, a round cylindrical or substantially round cylindrical surface around or substantially around the axis x. Moreover, as illustrated in Fig. 16, the holding portion 47 has, for example, side surfaces 47a, 47b, which are surfaces facing opposite sides to each other in the direction of the axis x, and has a rectangular or substantially rectangular cross-sectional shape. The side surface 47b, which is connected with the inner peripheral surface 46b of the fitting portion 46, extends along a plane perpendicular to the axis x and, for example, extends on a plane parallel or substantially parallel with the plane perpendicular to the axis x.

The fitting portion 46 of the holding member 45 is fittable to the outer peripheral edge portion 74a of the cover portion 74 of the elastic body portion 70. Specifically, for example, a diameter of the inner peripheral surface 46b of the fitting portion 46 is smaller than a diameter of the fitting surface 75 of the outer peripheral edge portion 74a of the cover portion 74. The cover portion 74 of the elastic body portion 70 is thus to be press-fitted in the fitting portion 46 of the holding member 45 to fix the holding member 45 to the elastic body portion 70.

As illustrated in Fig. 16, the electrically conductive member 3 is held between the holding portion 47 of the holding member 45 and the holding surface 77 of the cover portion 74 of the elastic body portion 70. Specifically, the side surface 47b of the holding portion 47 is in contact with the respective side surfaces 23a, 25a of the respective bases 23, 25 of the electrical conductors 21, 22 of the electrically conductive member 3, so that the bases 23, 25 are pressed against the holding surface 77 of the cover portion 74. As described above, the holding member 45 is fixed to the elastic body portion 70 in a state where the fitting portion 46 of the holding member 45 is fitted to the outer peripheral edge portion 74a of the cover portion 74 of the elastic body portion 70 and the holding portion 47 presses the bases 23, 25 against the holding surface 77 of the cover portion 74. It should be noted that an edge portion 46c of the fitting portion 46 of the holding member 45 may be provided with a projection 48, which is to be housed in the recess 76 of the cover portion 74 (see Fig. 16). Thee projection 48 is housed in the recess 76 as the fitting portion 46 of the holding member 45 is fitted to the outer peripheral edge portion 74a of the cover portion 74 of the elastic body portion 70 as described above, which makes it possible to more firmly fix the holding member 45 to the elastic body portion 70 in a state where the holding portion 47 presses the bases 23, 25 against the holding surface 77 of the cover portion 74.

In the electrically conductive sealing device 5, the contact portions 24, 26 of the electrical conductors 21, 22 are to come into contact with the outer peripheral surface of the shaft of the installation object. Moreover, the contact portions 24, 26 of the electrical conductors 21, 22 project opposite the sealing-object side as illustrated in Fig. 16.

Moreover, the side surface 47b of the holding portion 47 of the holding member 45 is provided with the projections 2a, 2b of the above-described electrically conductive structure 1 in a similar manner. In the electrically conductive sealing device 5, the projections 2a, 2b are housed in the gaps 11, 12 of the electrically conductive member 3, respectively. Moreover, the projection 2a is in contact with the end 21a of the electrical conductor 21 and the end 22a of the electrical conductor 22. Moreover, the projection 2b is in contact with the end 21b of the electrical conductor 21 and the end 22b of the electrical conductor 22. It should be noted that in the gap 11, a gap may be formed between the projection 2a and the end 21a of the electrical conductor 21. Moreover, in the gap 11, a gap may be formed between the projection 2a and the end 22a of the electrical conductor 22. Likewise, in the gap 12, a gap may be formed between the projection 2b and the end 21b of the electrical conductor 21. Moreover, in the gap 12, a gap may be formed between the projection 2b and the end 22b of the electrical conductor 22. It should be noted that the projections 2a, 2b may be provided not on the side surface 47b of the holding portion 47 of the holding member 45 but on the holding surface 77 of the cover portion 74 of the elastic body portion 70 in a manner such that the projections 2a, 2b are likewise housed in the gaps 11, 12, respectively. Moreover, the projections 2a, 2b may also be provided on the holding surface 77 of the cover portion 74 of the elastic body portion 70 in addition to the side surface 47b of the holding portion 47 of the holding member 45. Moreover, a plurality of projections 2a may be provided. Moreover, a plurality of projections 2b may be provided.

The component members of the electrically conductive sealing device 5, which have the configurations as described above, are assembled into the assembled state, serving as the electrically conductive sealing device 5 as illustrated in Fig. 16. In the electrically conductive sealing device 5, the fitting portion 46 of the holding member 45 is fitted to the outer peripheral edge portion 74a of the cover portion 74 of the elastic body portion 70 and the electrical conductors 21, 22 are sandwiched between the holding portion 47 of the holding member 45 and the holding surface 77 of the cover portion 74 of the elastic body portion 70. As seen from the above, the holding member 45 is fixed to the elastic body portion 70 and the electrical conductors 21, 22 are fixed between the holding member 45 and the elastic body portion 70. Moreover, the electrical conductors 21, 22 are attached between the holding member 45 and the elastic body portion 70 in a manner such that the respective contact portions 24, 26 project opposite the seal lip 71. It should be noted that the electrical conductors 21, 22 may be attached with the respective contact portions 24, 26 projecting toward the seal lip 71 unless there is an interference with, for example, the elastic body portion 70.

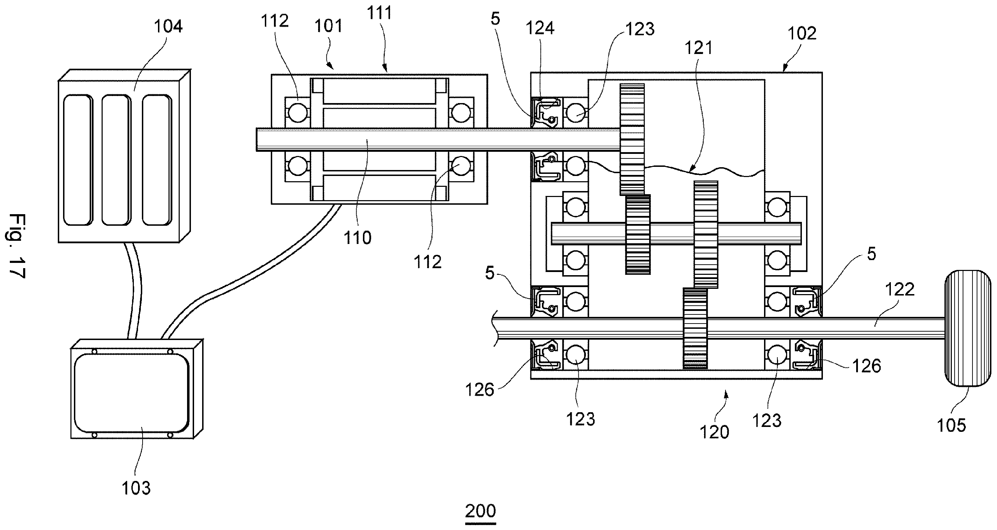

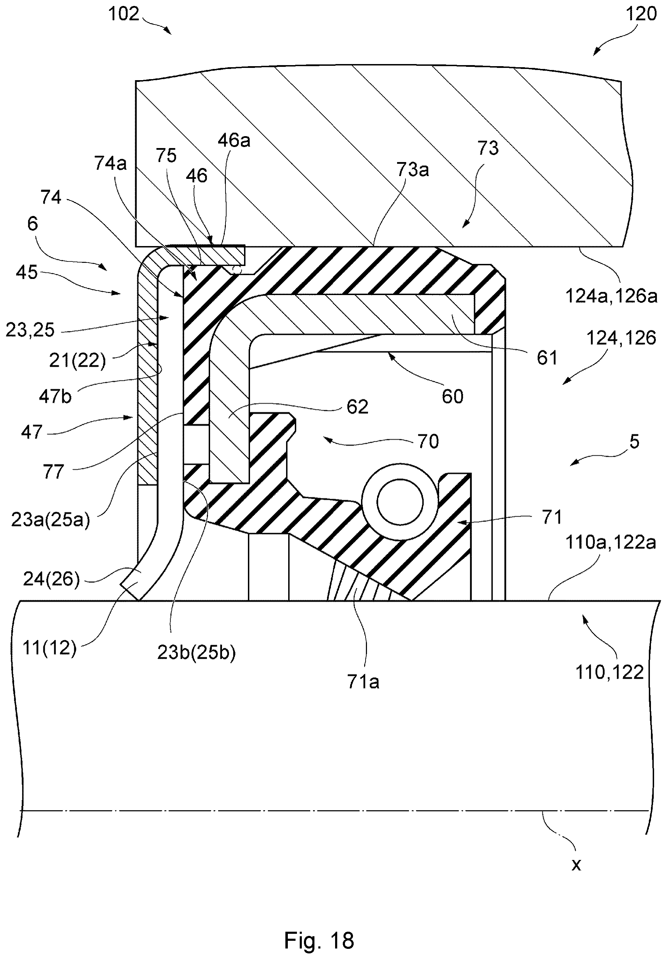

Fig. 17 is a schematic diagram for illustrating an example of the installation object of the electrically conductive sealing device 5. Fig. 18 is a cross-sectional view illustrating an example of a use state of the electrically conductive sealing device 5 in the installation object illustrated in Fig. 17. The electrically conductive sealing device 5 is installed in, by way of example, a drive device 200 of a battery electric vehicle (BEV) as illustrated in Fig. 17. The drive device 200 is similar in configuration to the above-described drive device 100 (see Figs. 9 and 10) but different from the drive device 100 in that no electrically conductive structure 1 is attached. Moreover, the drive device 200 is attached with the electrically conductive sealing device 5 in place of the oil seals 125, 127 of the drive device 100. The electrically conductive sealing device 5 is put in the use state by, by way of example, being provided between the housing 120 of the decelerator 102 and each of the shafts 110, 122. Specifically, the electrically conductive sealing device 5 is put in the use state by fit-attaching the gasket portion 73 of the elastic body portion 70 to each of the shaft holes 124, 126 of the housing 120 to fix the electrically conductive sealing device 5 to each of the shaft holes 124, 126 and inserting each of the shafts 110, 122 in the seal lip 71 and electrically conductive member 3. In the use state, the seal lip 71 is in contact with each of the outer peripheral surfaces 110a, 122a of the shafts 110, 122 to perform sealing of the sealing-object side. Moreover, in the use state, the respective inner peripheral edges 24c, 26c of the electrical conductors 21, 22 of the electrically conductive member 3 are in contact with each of the outer peripheral surfaces 110a, 122a of the shafts 110, 122. Moreover, the holding member 45, which is attached with the electrically conductive member 3, is made of a metal with electrical conductivity and is in contact with each of inner peripheral surfaces 124a, 126a of the shaft holes 124, 126 of the housing 120. As seen from the above, the electrically conductive member 3 and the holding member 45 form an electrically conductive path for electricity to flow between each of shafts 110, 122 and the housing 120 in the use state.

It should be noted that the above-described drive device 200 is an example of the installation object of the electrically conductive sealing device 5 and the installation object of the electrically conductive sealing device 5 is not limited thereto. The electrically conductive sealing device 5 is usable in, for example, a drive device for an electric vehicle (EV), such as a hybrid vehicle (HV) or a fuel cell vehicle (FCV), or the like in addition to a battery electric vehicle (BEV). There are cases where a vehicle equipped with an electric motor, such as an electric vehicle (EV), suffers the generation of an electromagnetic noise due to an induced current generated by the motor, or the like. Moreover, there are cases where an electromagnetic noise occurs due to an on/off operation of an inverter for a control of an electric current to be supplied to a motor such as an electric motor, an induced voltage of the motor itself, or the like. As described above, the electrically conductive sealing device 5 forms the electrically conductive paths to cause the electromagnetic noise transmitted to the shafts 110, 122 to flow into the housing 120. This makes it possible to prevent the occurrence of a communication failure or a malfunction of electronic equipment and the occurrence of electrolytic corrosion of a metal part such as a bearing.

The electrically conductive structure 6 of the electrically conductive sealing device 5 is also to be used as the above-described electrically conductive structure 1 to form an electrically conductive path. Moreover, the electrically conductive structure 6 also makes it possible to eliminate the necessity for a lubricant as the electrically conductive structure 1, so that it is possible to reduce, in the use state, a decrease in electrically conductive performance of the electrically conductive structure 6. Moreover, in the electrically conductive member 3 of the electrically conductive sealing device 5, even though an external force is applied to the electrical conductors 21, 22 by rotations of the shafts 110, 122, it is also possible to reduce, in the electrical conductors 21, 22, the occurrence of a deformation or a contact with the shafts 110, 122 likely to lead to the occurrence of stress concentration. From this point of view, the electrically conductive sealing device 5 also makes it possible to eliminate the necessity of providing a lubricant with electrical conductivity between the electrical conductors 21, 22 and the shafts 110, 122 as the electrically conductive structure. Moreover, the electrically conductive structure 6, which is to be attached within a width in the radial direction of the sealing device, requires no space to attach the electrically conductive structure 6 and thus enables the saving of space. Moreover, in the electrically conductive sealing device 5, it is also possible to reduce the occurrence of a deformation such as a crease in the electrical conductors 21, 22 in fixing the electrically conductive member 3 between the holding member 45 and the elastic body portion 70. Moreover, it is also possible to efficiently manufacture the electrical conductors 21, 22 of the electrically conductive structure 6 with an excellent yield. Moreover, in the electrically conductive sealing device 5, the electrical conductors 21, 22 do not also rotate with respect to the holding member 45 and the elastic body portion 70 with rotations of the shafts 110, 122.

Moreover, the electrically conductive member 3 of the electrically conductive structure 6 has the gaps 11, 12 between the electrical conductor 21 and the electrical conductor 22. The gaps 11, 12 are through holes penetrating the electrically conductive member 3 in the direction of the axis x, thus forming through holes penetrating the electrically conductive member 3 in the direction of the axis x between the shafts 110, 122 and the shaft holes 124, 126 in the use state of the electrically conductive sealing device 5. As illustrated in Fig. 16, the seal lip 71 includes a plurality of spirally extending projections 71a and the projections 71a produce a pump effect. Thus, the seal lip 71 draws air into the sealing-object side in the use state. Since the electrically conductive member 3 forms the through holes penetrating the electrically conductive member 3 in the direction of the axis x between the shafts 110, 122 and the shaft holes 124, 126 as described above, a space between the electrical conductors 21, 22 of the electrically conductive member 3 and the seal lip 71 is not put into a negative-pressure state even though air is drawn into the sealing-object side by the pump effect of the seal lip 71. This makes it possible to prevent an increase in wear and sliding resistance of the seal lip 71 and prevent an increase in wear and sliding resistance of the electrical conductors 21, 22 of the electrically conductive member 3.

Therefore, the electrically conductive sealing device 5 according to the first embodiment of the present invention enables space and, in the use state, reducing a decrease in electrically conductive performance.

It should be noted that the electrically conductive structure 6 of the electrically conductive sealing device 5 also has a variety of modification examples as the electrically conductive structure 1.

Hereinabove, the present invention is described through the above-described embodiments but the technical scope of the present invention is not limited to the scope according to the above-described embodiments. It is obvious to those skilled in the art that the above-described embodiments may be modified or improved in a variety of manners. It is obvious from the description of the claims that forms applied with such modifications or improvements are within the technical scope of the present invention.

The embodiments described hereinabove are merely for the purpose of facilitating the understanding of the present invention and should not be interpreted to limit the present invention. Moreover, the above-described embodiments will not limit an application object to which the present invention is to be applied and the present invention may encompass anything as the application object. The components of the above-described embodiments and the locations, materials, conditions, shapes, sizes, and the like thereof are not limited to the exemplified ones and may be changed as appropriate. For example, the present invention encompasses a difference resulting from implementation, such as a manufacturing tolerance. Moreover, the components according to the different embodiments may be partially replaced or combined with each other insofar as it is not technically inconsistent. Moreover, the configurations may be selectively combined as appropriate so that at least a part of the above-described problem and effects are achieved.

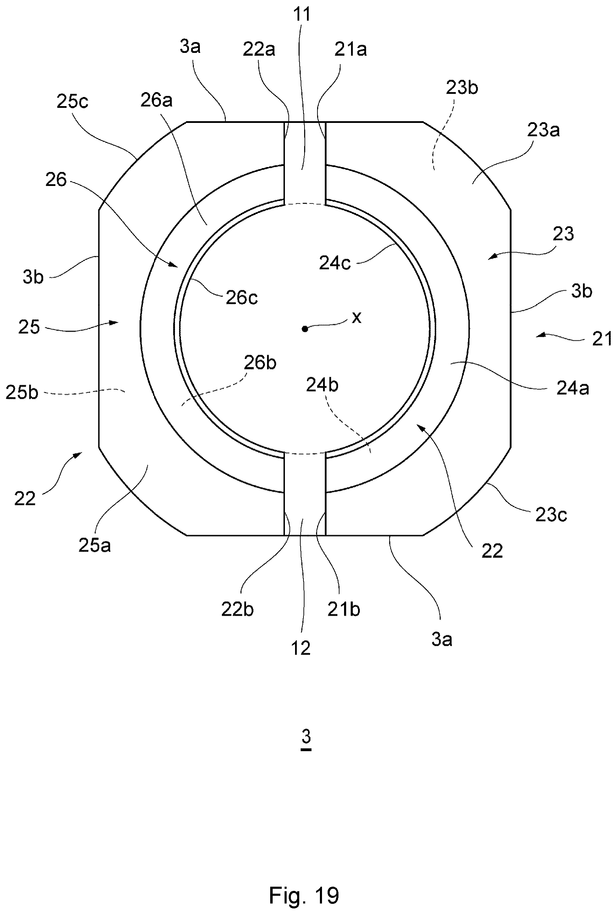

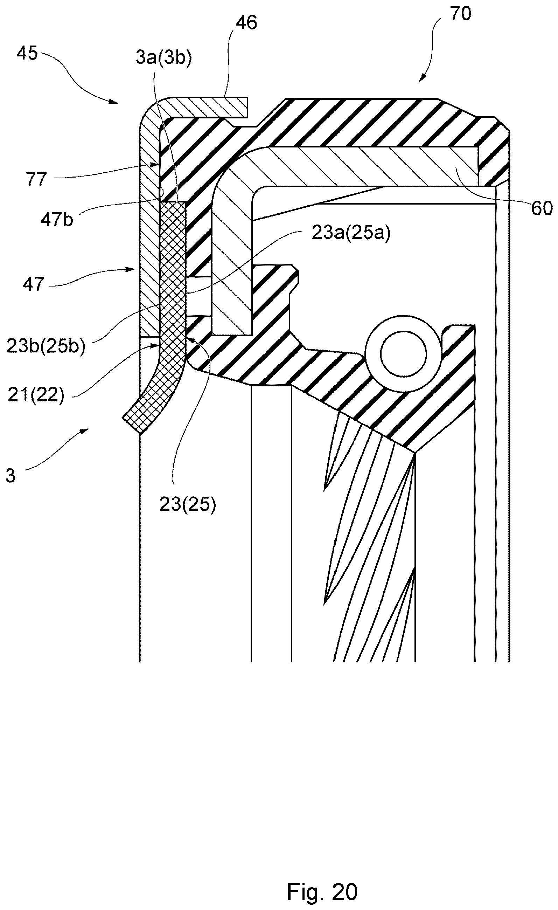

For example, the shape of the outer peripheral edge (the edges 23c, 25c) of the electrically conductive member 3 may be a shape including a linear portion along a straight line in place of the shape along a circle. For example, two pairs of linear portions, a pair of linear portions 3a and a pair of linear portions 3b, may be provided in the outer peripheral edge (the edges 23c, 25c) of the electrically conductive member 3 as illustrated in Fig. 19. In this case, the holding members 2, 7 or the cover portion 74 of the elastic body portion 70 is provided with configurations such as steps, protrusions, or the like corresponding to the respective linear portions, which makes it possible to prevent a rotation of the electrical conductors 21, 22. For example, as illustrated in Fig. 20, the holding surface 77 of the cover portion 74 of the elastic body portion 70 of the electrically conductive sealing device 5 may be provided with a recess 77a forming an outline corresponding to an outline of the outer peripheral edge of the electrically conductive member 3 as illustrated in Fig. 19 so that the electrically conductive member 3 is housed in the recess 77a. In this case, neither of the projections 2a, 2b may be provided. Even though neither of the projections 2a, 2b is provided, it is possible to prevent the electrical conductors 21, 22 from rotating with respect to the holding member 45 and the elastic body portion 70 with a rotation of the shaft 110. Moreover, the electrical conductor 20 (the electrical conductors 21, 22) may be bonded to the holding members 2, 7 and the elastic body portion 70 with an adhesive. In this case, the adhesive is applied in a manner not to become a resistance to the electrically conductive path. Moreover, in this case, an adhesive with electrical conductivity is used.

### [Reference Signs List]

1, 4, 6 electrically conductive structure, 2, 7 holding member, 2a, 2b projection, 3, 3A electrically conductive member, 3a, 3b linear portion, 5 electrically conductive sealing device, 10, 11, 12 gap, 20, 21, 22 electrical conductor, 20a, 20b, 21a, 21b, 22a, 22b end, 23, 25 base, 23a, 23b, 25a, 25b side surface, 23c, 25c edge, 24, 26 contact portion, 24a, 24b, 26a, 26b side surface, 24c, 26c inner peripheral edge, 30 internal holding member, 31 fitting portion, 31a outer peripheral surface, 31b inner peripheral surface, 31c edge, 32 holding portion, 32a, 32b side surface, 32c edge, 40 external holding member, 45 holding member, 41, 46 fitting portion, 41a, 46a outer peripheral surface, 41b, 46b inner peripheral surface, 42, 47 holding portion, 42a, 42b, 47a, 47b side surface, 42c edge, 43 retaining portion, 46c edge portion, 48 projection, 50 spring member, 51 base, 52 resilient portion, 60 reinforcing ring, 61 cylindrical portion, 62 ring portion, 70 elastic body portion, 71 seal lip, 71a projection, 72 base, 73 gasket portion, 73a outer peripheral surface, 74 cover portion, 74a outer peripheral edge portion, 75 fitting surface, 76 recess, 77 holding surface, 77a recess, 100, 200 drive device, 101 electric motor, 102 decelerator, 103 inverter, 104 battery, 105 wheel, 110, 122 shaft, 110a, 122a outer peripheral surface, 111, 120 housing, 121 reduction gear stage, 112, 123 bearing, 113, 124, 126 shaft hole, 113a, 124a, 126a inner peripheral surface, 125, 127 oil seal, x axis

## Claims

1. An electrically conductive structure comprising:
a holding member that is an annular member with electrical conductivity around an axis; and
an electrically conductive member that is an annular member around the axis, wherein
the electrically conductive member has at least one gap formed to extend in a radial direction and includes at least one electrical conductor with electrical conductivity extending around the axis,
the electrically conductive member is held by the holding member,
the electrical conductor has a pair of ends in a direction around the axis, and
the gap is continuous with the ends of the electrical conductor.

2. The electrically conductive structure according to claim 1, wherein
the electrically conductive member includes the single electrical conductor and has the single gap,
the pair of ends of the electrical conductor face each other in the direction around the axis, and
the gap is a gap between the facing ends of the electrical conductor.

3. The electrically conductive structure according to claim 1, wherein
the electrically conductive member includes the two electrical conductors and has the two gaps,
one of the pair of ends of one of the electrical conductors faces one of the pair of ends of another one of the electrical conductors in the direction around the axis,
another one of the pair of ends of the one of the electrical conductors faces another one of the pair of ends of the other one of the electrical conductors in the direction around the axis,
one of the gaps is formed between the one of the ends of the one of the electrical conductors and the one of the ends of the other one of the electrical conductors, and
another one of the gaps is formed between the other one of the ends of the one of the electrical conductors and the other one of the ends of the other one of the electrical conductors.

4. The electrically conductive structure according to claim 1, wherein
the electrical conductor is held by the holding member on an outer peripheral side.

5. The electrically conductive structure according to claim 1, comprising
an annular spring member around the axis, wherein
the spring member is configured to generate an elastic force in a direction toward the axis, and
the spring member and the electrically conductive member are provided side by side in a direction of the axis.

6. The electrically conductive structure according to claim 1, wherein
the holding member includes at least one projecting portion that is to be housed in the gap, and
the projecting portion projects in a direction of the axis.

7. The electrically conductive structure according to claim 1, wherein
the electrical conductor is made of PTFE with electrical conductivity.

8. An electrically conductive sealing device for sealing between a shaft and a hole where the shaft is inserted, the electrically conductive sealing device comprising:
a reinforcing ring that is an annular member around an axis;
an elastic body portion formed of an annular elastic body around the axis attached to the reinforcing ring; and
an annular electrically conductive structure around the axis, wherein
the elastic body portion includes a seal lip that comes into contact with the shaft,
the electrically conductive structure includes a holding member that is an annular member around the axis and an electrically conductive member that is an annular member around the axis,
the electrically conductive member has at least one gap formed to extend in a radial direction and includes at least one electrical conductor with electrical conductivity extending around the axis,
the holding member is attached to the elastic body portion with the electrical conductor held between the holding member and the elastic body portion,
the electrical conductor has a pair of ends in a direction around the axis, and
the gap is continuous with the ends of the electrical conductor.

9. The electrically conductive sealing device according to claim 8, wherein
the electrically conductive member includes the single electrical conductor and has the single gap,
the pair of ends of the electrical conductor face each other in the direction around the axis, and
the gap is a gap between the facing ends of the electrical conductor.

10. The electrically conductive sealing device according to claim 8, wherein
the electrically conductive member includes the two electrical conductors and has the two gaps,
one of the pair of ends of one of the electrical conductors faces one of the pair of ends of another one of the electrical conductors in the direction around the axis,
another one of the pair of ends of the one of the electrical conductors faces another one of the pair of ends of the other one of the electrical conductors in the direction around the axis,
one of the gaps is formed between the one of the ends of the one of the electrical conductors and the one of the ends of the other one of the electrical conductors, and
another one of the gaps is formed between the other one of the ends of the one of the electrical conductors and the other one of the ends of the other one of the electrical conductors.

11. The electrically conductive sealing device according to claim 8, wherein
the holding member includes at least one projecting portion that is to be housed in the gap, and
the projecting portion projects in a direction of the axis.

12. The electrically conductive sealing device according to claim 8, wherein
the electrical conductor is made of PTFE with electrical conductivity.
